# EUROPEAN PATENT SPECIFICATION

(11) **EP 2 597 068 B1**
(45) Date of publication and mention of the grant of the patent: **18.02.2015**
(21) Application number: 11823422.8
(22) Date of filing: 25.08.2011
(51) Int. Cl.: C01B 31/02, B01J 23/755, D01F 9/127, B82Y 30/00, D01F 9/133

(54) **MICRO COIL MANUFACTURING METHOD AND MANUFACTURING DEVICE THEREOF**
VERFAHREN FÜR MIKROSPULE UND VORRICHTUNG ZU IHRER HERSTELLUNG
PROCÉDÉ DE FABRICATION DE MICRO-BOBINE ET DISPOSITIF POUR SA FABRICATION

(30) Priority: 10.09.2010 JP 2010202697
(43) Date of publication of application: 29.05.2013
(73) Proprietor: Cmc Advanced R&D. Co. Ltd., Nagano 399-3202 (JP)
(72) Inventor: MOTOJIMA, Seiji, Gifu-shi Gifu-ken 5020813 (JP)
(74) Representative: Prüfer & Partner GbR European Patent Attorneys
(86) International application number: PCT/JP2011/069151
(87) International publication number: WO 2012/032943

(56) References cited:
- GB-A- 2 233 971
- JP-A- 2002 201 532
- JP-A- 2003 213 530
- JP-A- 2004 261 630
- JP-A- 2007 045 637
- JP-A- 2009 214 021
- JP-A- 2010 095 405
- US-A1- 2003 012 721
- US-A1- 2003 148 097

## Description

The present invention relates to a micro coil and a manufacturing method thereof and an apparatus thereof.

Conventionally, as this kind of a manufacturing apparatus, a manufacturing apparatus of a coil-shaped carbon fiber disclosed in Japanese Patent Application Laid-Open No. 11-081051(1999-081051) is proposed. The manufacturing apparatus includes a cylindrical reaction container which is necessary to grow a coil-shaped carbon fiber.

Further, the reaction container is provided with an inlet, a pair of injection holes, and an outlet. The inlet is formed at the center upper peripheral surface of the reaction container in a protruding manner. Thus, the inlet serves to introduce a source gas such as a hydrocarbon gas or a carbon monoxide gas into the reaction container. The pair of injection holes is formed at the upper peripheral surfaces of both ends of the reaction container in a protruding manner. Thus, the pair of injection holes serves to inject a seal gas into the reaction container.

Further, the outlet is formed at the center lower peripheral surface of the reaction container in a protruding manner so as to correspond to the inlet. Thus, the outlet serves to discharge the source gas flowing into the reaction container or the seal gas injected into the reaction container.

In other words, the inlet and the pair of injection holes, as described above are formed in the reaction container so as to extend upward in the perpendicular direction from the upper portion of the reaction container thereby respectively to serve to exhibit their functions. And, the outlet, as described above is formed in the reaction container so as to extend downward in the perpendicular direction from the lower portion of the reaction container thereby respectively to serve to exhibit their functions.

In the manufacturing apparatus with such a construction, when the source gas is supplied from the inlet while the reaction container is heated to a predetermined temperature by a heater, the source gas flows into the reaction container downward, and is pyrolized or thermally decomposed inside the reaction container. Then, a carbon fiber which grows in a gas phase under the thermally decomposed source gas grows from a substrate which is received inside the reaction container while coating a metal catalyst on the substrate.

Incidentally, in the above-mentioned manufacturing apparatus, the inlet extends from the upper portion of the reaction container upwardly in the perpendicular direction, as described above. This means that the manufacturing apparatus adopts a method in which the source gas is forcedly introduced into the reaction container from the upside to the downside.

Accordingly, in such a manufacturing apparatus, a flow such as a convection of the source gas or a contact with the metal catalyst inside the reaction container is restricted by the construction of the inlet with respect to the above-described reaction container. As a result, a thermal decomposition reaction or a catalyst reaction hardly occurs inside the reaction container, and hence defects that a yield amount or a purity of a coil is very low arise.

Further, in the manufacturing apparatus, the inlet extends upward from the upper portion of the reaction container in the perpendicular direction, and the outlet extends downward in the perpendicular direction from the lower portion of the reaction container, as described above.

Accordingly, in the manufacturing apparatus, it is difficult to stack a plurality of reaction containers in the up and down directions. As a result, there occur defects that the coil-shaped carbon fibers may not be efficiently and massively produced.

US 2003/148097 A1 to disclose a manufacturing apparatus for performing a manufacturing method, the apparatus includes a cylindrical reactor, a substrate, a catalyst and a heater. From one lateral side of the reactor, a gas is supplied in the axial direction of the reactor, and from the other lateral side of the reactor, a gas is discharged in the axial direction of the reactor. The raw material gas is decomposed into carbon which adheres to the nucleus fine particle to form a carbon nano-fiber such as carbon nano-coil.

Other apparatuses or micro coils are known from JP 2010 095405 A; US 2003/012721 A1; JP 2009 214021 A; and GB 2 233 971 A.

It is therefore an object of the present invention to provide a manufacturing method of micro coils by performing satisfactorily the flow of the source gases or the contact with the catalyst inside the reaction container under ingenuity on introduction of the source gases into the reaction container and discharge of gases from the reaction container, and to provide a corresponding manufacturing apparatus of micro coils.

lateral direction facing wall portion of both lateral direction facing wall portions of said container body and to discharge gases in said container body from the other direction facing wall portion of both the lateral direction facing wall portions.

With this construction, the source gases introduced into the container body from one lateral direction facing wall portion of the container body of the reaction container flow smoothly and satisfactorily in the container body, thereby to perform satisfactorily the reaction with the catalyst of the substrate. Thus, the source gases introduced into the container body are thermally decomposed by the catalyst under the predetermined high temperature, thereby to produce satisfactorily the gaseous carbon species on the substrate. As a result, the micro coil can be obtained satisfactorily and efficiently by its growth from the substrate on a basis of the gaseous carbon species.

Further, according to the present invention, there is provided a manufacturing method of micro coils which comprises:
a heat process for heating and maintaining a cylindrical container body of a reaction container at a predetermined high temperature, said reaction container including said container body and a substrate inserted into said container body in the axial direction and carrying a

This object is achieved by the manufacturing method having the features of claim 1 and by the manufacturing apparatus having the features of claim 5, respectively. The present invention is further developed as defined in the dependent claims.

With this construction, the source gases are introduced from the predetermined one direction wall portion of the container body into the container body of the reaction container. Accordingly, the source gases introduced into the container body in this way flow smoothly and satisfactorily in the lateral direction or the upward direction in the container body, thereby to perform satisfactorily the reaction with the catalyst of the substrate.

Thus, under maintaining the container body at the predetermined high temperature, the source gases introduced into the container body are thermally decomposed by the catalyst to produce satisfactorily gaseous carbon species from the substrate. As a result, it is possible that growth and manufacture of micro coils from the substrate are performed satisfactorily and efficiently on a basis of the gaseous carbon species.

The present invention is characterized in that in the above-mentioned manufacturing method of micro coils, the predetermined one direction wall portion and the predetermined other direction wall portion of said reaction container may be respectively one lateral direction facing wall portion of both lateral direction facing wall portions of said container body and the other lateral direction facing wall portion of both the lateral direction facing wall portions.

With this construction, the source gases are introduced into the container body from its one lateral direction inside the reaction container. Thus, the source gases introduced into the container body in this way flow smoothly and satisfactorily toward the other lateral direction opposite to the one lateral direction inside the container body, thereby to be capable of performing satisfactorily the reaction with the catalyst of the substrate.

Further, according to the present invention, in the above-mentioned manufacturing method of micro coils, the predetermined one direction wall portion and the predetermined other direction wall portion of said reaction container may be respectively one downward facing wall portion of both upward and downward facing wall portions of said container body and the other upward facing wall portion of both the upward and downward facing wall portions.

With the construction, the source gases are introduced into the container body from the downside thereof in the reaction container. Thus, the source gases introduced into the container body in this way flow smoothly and satisfactorily upward in the container body, thereby to perform the reaction with the catalyst of the substrate satisfactorily. As a result, it is possible to obtain substantially the same operation and effect as those of the above-described manufacturing method.

Still further, according to the present invention, in the above-mentioned manufacturing method of micro coils, said substrate may include a cylindrical base body which is inserted into said cylindrical container body in the axial direction to carry the catalyst on the outer peripheral surface thereof, and at the source gas introduction process, the source gases introduced into said cylindrical container body which is maintained at the predetermined temperature may be thermally decomposed by the catalyst so as to produce gaseous carbon species on the outer peripheral surface of said cylindrical base body, thereby to grow and manufacture the micro coils on the outer peripheral surface of said cylindrical base body on a basis of the gaseous carbon species.

In this way, the substrate is the cylindrical base body which is inserted into the cylindrical container body in the axial direction and carries the catalyst on the outer peripheral surface. Thus, micro coils grow from the outer peripheral surface of the cylindrical base body. As a result, it is possible to manufacture further efficiently the micro coils in large quantities.

Still further, according to the present invention, in the above-mentioned manufacturing method of micro coils, the source gases may be a mixed gas which include an acetylene gas, a hydrogen gas and a hydrogen sulfide gas, and at the heat process, the predetermined high temperature is set as a temperature within the range of 600 °C to 900 °C and said container body is heated and maintained at the temperature.

Accordingly, the source gases are the mixed gas including the acetylene gas, the hydrogen gas, and the hydrogen surfide gas. Thus, the source gases do not include an ingredient harmful to the source gases like a nitrogen gas or a thiophene gas. From this reason, the thermal decomposition by the reaction of the source gases with the catalyst is satisfactorily performed. As a result, it is possible to grow micro coils further satisfactorily.

In the manufacturing apparatus, thus, at least one source gas introduction pipe is extended from the predetermined one direction wall portion of the container body, and at least one gas discharge pipe is extended toward the direction opposite to the at least one source gas introduction pipe from the predetermined other direction wall portion of the container body.

For this reason, the source gases introduced into the container body in this way flow smoothly and satisfactorily in the lateral direction or the upward direction along the substrate inside the container body, thereby to be capable of performing the reaction with the catalyst of the substrate satisfactorily. Accordingly, under maintaining the container body at the predetermined high temperature, the source gases introduced into the container body are thermally decomposed by the catalyst, thereby to be capable of producing gaseous carbon species on the substrate satisfactorily.

Further, according to the present invention, in the manufacturing apparatus of micro coils, the predetermined one and other direction wall portions of said reaction container are respectively one and the other lateral direction facing wall portions of both lateral direction facing wall portions of said container body.

With this construction, the at least one source gas introduction pipe is extended from the container body toward one lateral direction and the at least one gas discharge pipe is extended toward a direction opposite to the one lateral direction from the container body.

From this reason, the source gases introduced into the container body, as described above flow smoothly and satisfactorily toward the lateral direction along the substrate in the container body, thereby to be capable of performing the reaction with the catalyst of the substrate satisfactorily. Thus, the source gases introduced into the container body which is maintained at the predetermined high temperature are thermally decomposed by the catalyst, thereby to be capable of producing gaseous carbon species on the substrate satisfactorily. As a result, it is possible to satisfactorily perform efficiently growth and manufacture of micro coils from the substrate on a basis of the gaseous carbon species.

Furthermore, the source gas introduction pipe and the gas discharge pipe may be extended toward the opposite directions to each other in the lateral direction of the reaction container, as described above. Accordingly, even when a plurality of the reaction containers are stacked, the source gas introduction pipe of each reaction container does not interfere with an upper or lower source gas introduction pipe, and also the gas discharge pipe of each reaction container does not interfere with an upper or lower gas discharge pipe. Thus, the respective reaction containers can be easily stacked toward the up-and-down direction.

And still further, according to the present invention, in the manufacturing apparatus of micro coils, as described above, said substrate may include a cylindrical base body inserted into the cylindrical container body in the axial direction to carry the catalyst on its outer peripheral surface.

With this construction, the source gases introduced into the cylindrical container body flow along the outer peripheral surface of the cylindrical base body, thereby to grow micro coils from the cylindrical base body by reaction with the catalyst and thermal decomposition thereof based on the reaction. Accordingly, the growth area of micro coils is expanded or spread over the entirety of the outer peripheral surface of the cylindrical base body. As a result, it is possible to grow efficiently micro coils further massively or in further large quantities.

Furthermore, according to the present invention, in the manufacturing apparatus of micro coil as described above, said cylindrical substrate may include a cylindrical base body and a catalyst layer, said catalyst layer being formed from nickel which is subjected to a partial oxidization treatment and a partial sulfurization treatment at its surface and coated as a catalyst on the outer peripheral surface of said cylindrical base body with a thickness within the range of 2 (µm) to 6 (µm) so as to be carried on the outer peripheral surface of said cylindrical base body.

With forming the catalyst layer in this way, it is possible to perform further satisfactorily the thermal decomposition by the reaction of the source gases with the catalyst.

Further, according to the present invention, in the manufacturing apparatus of micro coils as described above, said at least one source gas introduction pipe may be a plurality of source gas introduction pipes which are extended at an interval within twenty times the inner diameter of said source gas introduction pipe in the axial direction of said cylindrical substrate from a portion corresponding to the length of 1/3 or more of the axial length of said cylindrical substrate, and a radial direction facing interval between the outer peripheral surface of said cylindrical substrate and an inner end opening portion of said source gas introduction pipe may be set to a value within the range of 5 (mm) to 50 (mm).

With this construction, it is possible to perform efficiently the reaction of the source gases in the container body with the catalyst of the cylindrical substrate.

Still further, according to the present invention, in the manufacturing apparatus of micro coils as described above, the manufacturing apparatus includes respective pluralities of said casing, said reaction container, said substrate and said heat controller.

In the manufacturing apparatus, a plurality of said casings are respectively stacked in the up-and-down direction. A plurality of said reaction containers are inserted at each cylindrical container body thereof into each corresponding casing of a plurality of said casings in the axial direction, each at least one source gas introduction pipe of a plurality of said reaction containers being extended outwardly from the one lateral direction wall portion of each corresponding cylindrical container body, and each at least one gas discharge pipe of a plurality of said reaction containers being extended outwardly from the other lateral direction wall portion, wherein a plurality of said substrates are inserted respectively into the corresponding container bodies in the axial direction to carry each catalyst so as to face it to each inner peripheral surface of the corresponding container bodies, wherein a plurality of said heat controllers perform respectively a heating control so as to maintain the corresponding container bodies at the predetermined high temperature. And the source gases inside each corresponding container body are thermally decomposed by each corresponding catalyst under maintaining each corresponding container body at the predetermined high temperature so as to produce gaseous carbon species on each corresponding substrate, thereby to grow micro coils from each corresponding substrate on a basis of the gaseous carbon species.

With this construction, the manufacturing apparatus is constructed by stacking a plurality of the manufacturing apparatus each having a single casing toward the up and down direction. Accordingly, it is possible to manufacture micro coils in further larger quantities. Furthermore, in the above-described stacking construction, the source gas introduction pipe and the gas discharge pipe are extended in the opposite directions to each other in the lateral direction of the reaction container as described above. Thus, the respective reaction containers can be easily stacked without any interferences of the source gas introduction pipe and the gas discharge pipe with upper or lower source gas introduction pipe and upper or lower gas discharge pipe.

The invention may be put into in various ways, but specific embodiments will be described by way of examples with reference to the accompanying drawings, in which:
Fig. 1 is a plan view illustrating a first preferred embodiment of a manufacturing apparatus of micro coils according to the present invention in a state where a main body is placed on an installation surface,
Fig. 2 is a block diagram illustrating a heating circuit of the first preferred embodiment,
Fig. 3 is a right side view illustrating the main body of the first preferred embodiment in a state placed it on the installation surface,
Fig. 4 is a left side view illustrating the main body of the first preferred embodiment in a state placed it on the installation surface,
Fig. 5 is a perspective cross-sectional view taken along the line 5-5 of Fig. 4 of the main body of the first preferred embodiment,
Fig. 6 is a perspective view illustrating a reaction container of the first preferred embodiment with a heater,
Fig. 7 is a perspective cross-sectional view of the reaction container of the first preferred embodiment.
Fig. 8 is a cross-sectional view illustrating the main body of the first preferred embodiment in a state where micro coils grow on an outer peripheral surface of a cylindrical substrate,
Fig. 9 is a manufacturing process of micro coils of the first preferred embodiment,
Fig. 10 is a diagram illustrating micro coils manufactured in the first preferred embodiment with a magnified photograph obtained by an electron microscope,
Fig. 11 is a diagram illustrating precipitates or deposits including micro coils manufactured in the first preferred embodiment with a magnified photograph obtained by the electron microscope,
Fig. 12 is a diagram illustrating other precipitates or deposits obtained in the first preferred embodiment with a magnified photograph obtained by the electron microscope,
Fig. 13 is a perspective cross-sectional view illustrating a main part of a third embodiment of the manufacturing apparatus of micro coils according to the present invention, and
Fig. 14 is a block diagram illustrating a heating circuit of the third embodiment.

Hereinafter, respective embodiments of the present invention will be described with reference to the drawings.

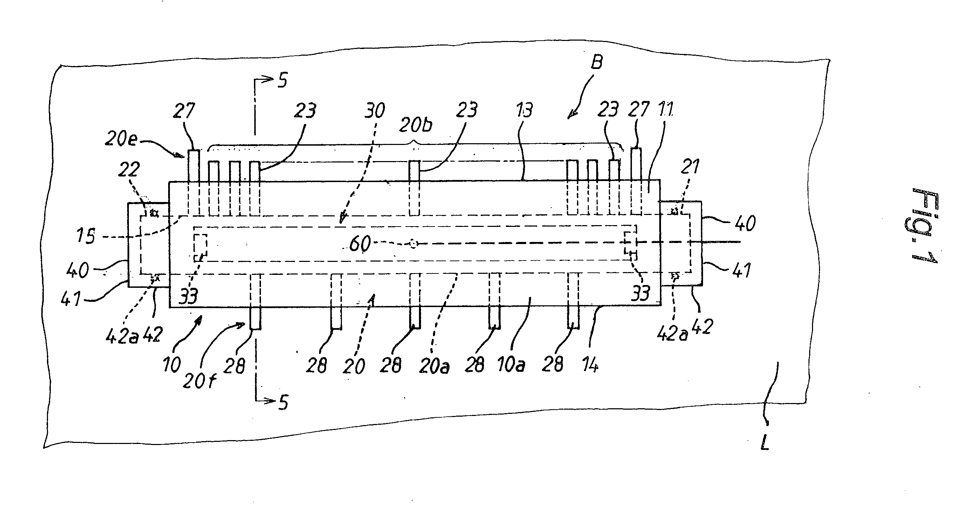

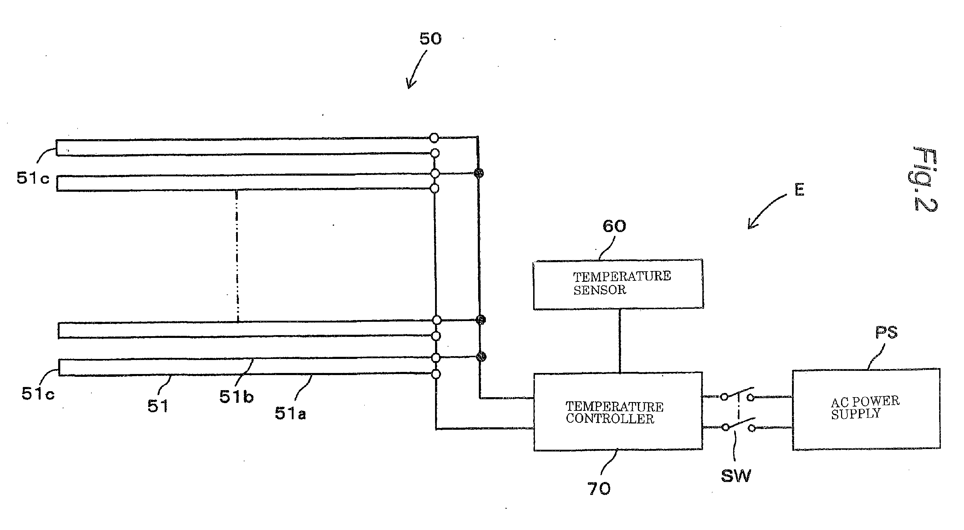

Figs. 1 and 2 illustrate a first preferred embodiment in which the present invention is applied to a manufacturing apparatus of micro coils. The manufacturing apparatus includes a main body B (see Fig. 1) and a heating circuit E (see Fig. 2). In the first embodiment, the micro coil is a micro coil that grows from carbon species, and is also called a carbon micro coil. This is induced from the reason why the coil diameter of the micro coil is µm order.

In addition, in Fig. 1, the left side and the right side of the drawing respectively correspond to the rear side and the front side of the main body B, and the upper side and the lower side of the drawing respectively correspond to the left side and the right side of the main body B. Further, in Fig. 1, the front side and rear side of the drawing paper respectively correspond to the upper side and the lower side of the main body B.

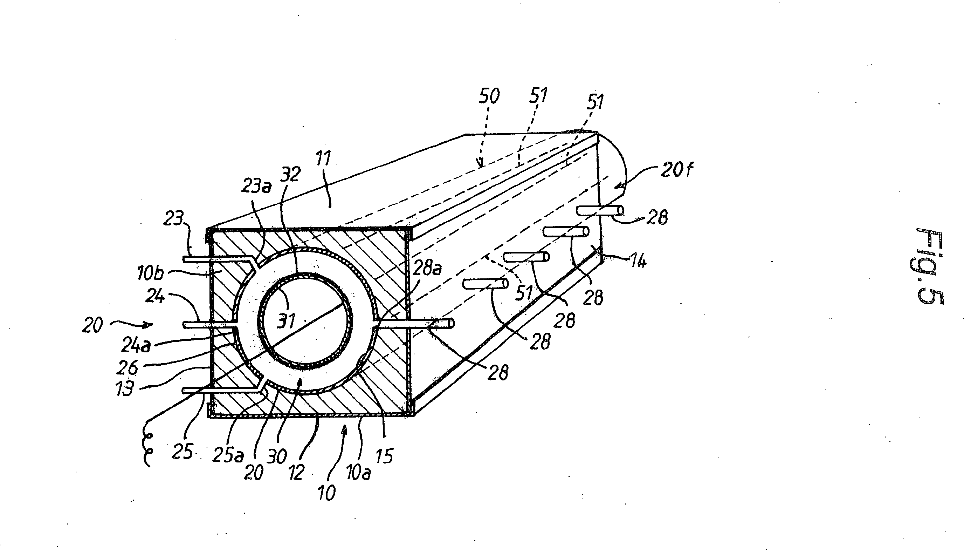

As illustrated in Fig. 1, the main body B includes a casing 10, a reaction container 20, a cylindrical substrate 30, and both front and rear side end covers 40. The casing 10 includes a cylinder body 10a in the form of a rectangular cross-sectional shape and an electrically insulating filling member 10b in the form of a prismatic shape (see Fig. 5).

The cylinder body 10a is, as illustrated in Fig. 5, formed by an upper wall 11 of a U-shaped cross-sectional shape, a lower wall 12 of a U-shaped cross-sectional shape, a left wall 13, and a right wall 14 with stainless steel so as to have a rectangular cylinder shape. Herein, the upper wall 11 is bent downward in an L-shape at both left and right edges thereof, thereby to be detachably attached to the respective upper edges of both left and right walls 13 and 14 from the outside. Further, the lower wall 12 is bent upward in an L-shape at both left and right edges thereof, thereby to be detachably attached to the respective lower edges of both left and right walls 13 and 14 from the outside.

The electrically insulating filling member 10b is formed with a flexible and electrical insulating material such as rock wool or the like so as to have a prismatic shape, and the filling member 10b is coaxially contained inside the cylinder body 10a.

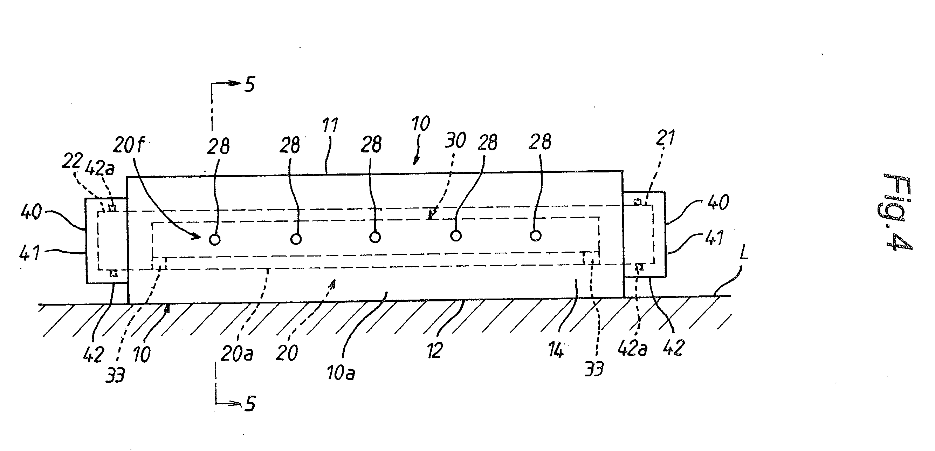

Accordingly, as described below, the filling member 10b serves to coaxially support a container body 20a inside the cylinder body 10a and to electrically insulating the container body 20a from the cylinder body 10a. In addition, for installing the main body B, casing 10 is normally placed at the lower wall 12 of the cylinder body 10a on the horizontal plane L of a base (see Figs. 1, 3, or 4).

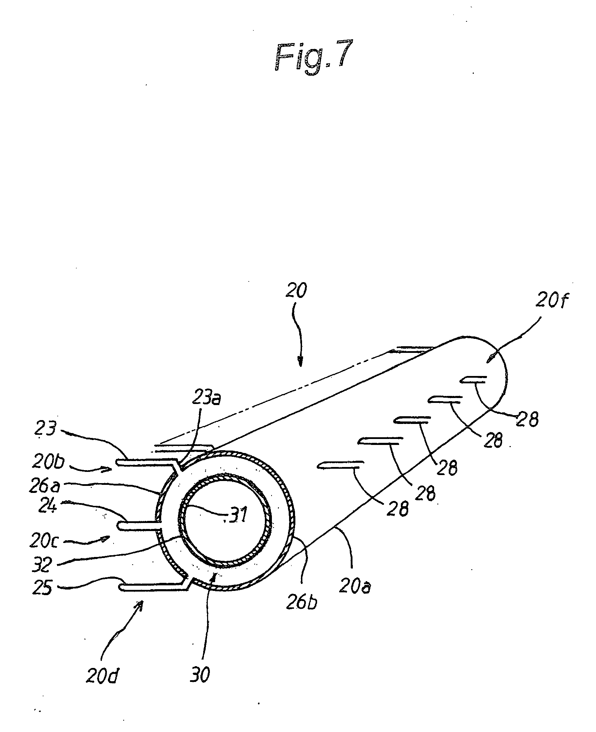

As illustrated in any one of Fig. 1 and Figs. 3 to 7, the reaction container 20 includes a cylindrical container body 20a, three sets of source gas introduction pipe groups 20b to 20d, a seal gas injection pipe group 20e, and a gas discharge pipe group 20f.

The container body 20a is formed from transparent quarts in the form of a cylindrical shape. The container body 20a is coaxially inserted through a through-hole portion 15 of the insulating filling member 10b.

Herein, the through-hole portion 15 is coaxially formed inside the insulating filling member 10b. Thus, the container body 20a is extended at both front and rear ends 21 and 22 thereof toward the opposite directions from both opening end portions of the cylinder body 10a and also both opening end portions of the insulating filling member 10b to be coaxially supported in the cylinder body 10a by the filling member 10b so as to be electrically insulated from the cylinder body 10a, as described above.

In the first embodiment, the reason why transparent quartz is adopted as a material of forming the container body 20a is based on the facts that the transparent quartz restrains catalytic activity, corrosion resistance to hydrogen sulfide or a side or vice reaction of a linear carbon fiber, a solid carbon film or carbon powders except for a micro coil generation reaction and that the interior of the container body 20a is easily seen through from the outside.

Further, the inner diameter of the container body 20a is preferably predetermined to be a value within the range of 30 (mm) to 300 (mm) from the point of a mixture of source gases (to be described later), a flow such as convection of the source gases, contact with a metal catalyst, an effective discharge of an exhaust gas or the like. It is more preferable that the inner diameter of the container body 20a is predetermined to be a value within the range of 100 (mm) to 150 (mm). In the first embodiment, the inner diameter of the container body 20a is predetermined to be 100 (mm).

The entire length of the container body 20a is preferably predetermined to be a value within the range of 600 (mm) to 2500 (mm). Further, it is more preferable that the entire length of the container body 20a is predetermined to be a value within the range of 1000 mm to 1800 mm. In the first embodiment, the entire length of the container body 20a is predetermined to be 1500 mm.

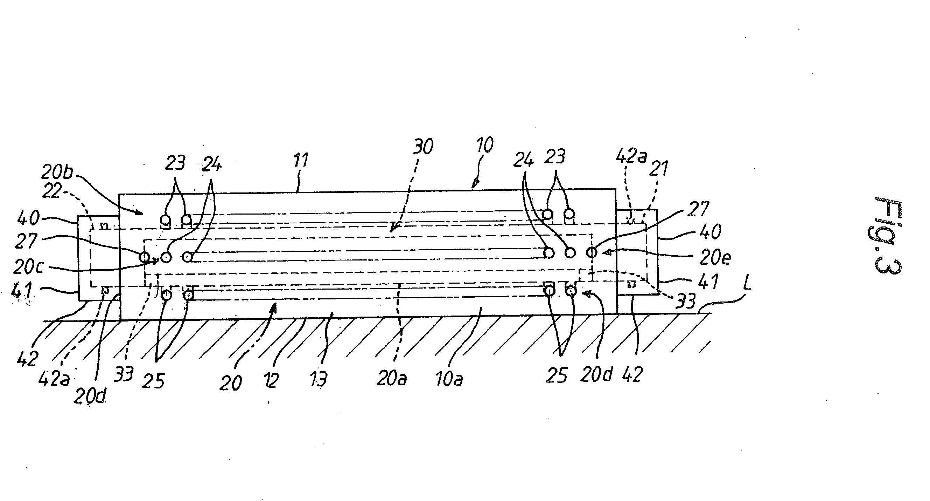

Three sets of source gas introduction pipe groups 20b to 20d serve to introduce source gases (to be described later) from source gas supply sources (not illustrated) into the container body 20a. The three set of the source gas introduction pipe groups 20b to 20d are extended leftward from a left semi-circular cylinder portion 26a of the container body 20a through the left wall 13 of the casing 10, as shown in any one of Figs. 3, 5, 6 and 7.

Herein, as the source gases, exemplified is other than a catalyst gas and a hydrogen gas a carbon monoxide gas or a hydrocarbon gas such as acetylene, methane or propane which is thermally decomposed to easily produce gaseous carbon species. Among these source gases, acetylene is most preferable. This is based on the reason why acetylene is thermally decomposed easily at a reaction temperature to react with a metal catalyst and exhibits efficiently the anisotropy of the catalyst activity in each crystal face of respective metal catalyst particles.

Therefore, in the first embodiment, the acetylene gas is adopted as the source gas together with a hydrogen gas and a hydrogen sulfide gas which is a catalyst gas. Further, as the catalyst gas, is exemplified a gas which includes the 15th and 16th groups of a periodic table and is a gas of a compound which includes a sulfur atom such as sulfur, thiophene, methyl mercaptan, hydrogen sulfide or the like or includes a phosphorus atom such as phosphorus, phosphorus trichloride or the like. Among the catalyst gases, the hydrogen sulfide gas is the most preferable from the viewpoint of the simplicity in use, the high yield amount of micro coils and the high yield rate of the micro coils.

Therefore, in the first embodiment, the hydrogen sulfide gas is adopted as the catalyst gas or as one of the source gases, as described above. The concentration in the reaction atmosphere of the hydrogen sulfide gas as the catalyst gas is predetermined to be a value within the range of 0.01 vol.% to 0.5 vol.%. And it is more preferable that the above-mentioned concentration is predetermined to be a value within the range of 0.05 vol.% to 0.2 vol.%.

Accordingly, in the first embodiment, the concentration of the hydrogen sulfide gas supplied into the container body 20a is predetermined so as to maintain the concentration in the reaction atmosphere in the concentration within the range of 0.05 vol.% to 0.2 vol.%.

In addition, when the concentration of the hydrogen sulfide gas becomes less than 0.01 vol.% or becomes higher than 0.5 vol.%, most of the growth of micro coils may not be obtained. Further, the flow quantity of the hydrogen sulfide gas is little. Thus, a hydrogen balance gas of a value within the range of 1 vol.% to 2 vol.% is used.

Among the three sets of the source gas introduction pipe groups 20b to 20d, the source gas introduction pipe group 20b is extend from the upper portion of the left semi-circular cylinder portion 26a of the container body 20a, the source gas introduction pipe group 20c is extend from the intermediate portion of the left semi-circular cylinder portion 26a, and the source gas introduction pipe group 20d is extend from the lower portion of the left semi-circular cylinder portion 26a.

In the upper, intermediate and lower portions of the left semi-circular cylinder portion 26a, the intermediate portion corresponds to the top and bottom direction center portion of the left semi-circular cylinder portion 26a of the container body 20a. Accordingly, the upper portion corresponds to the center portion between the intermediate portion and the upper end portion of the left semi-circular cylinder portion 26a. On the other hand, the lower portion corresponds to the center portion between the intermediate portion and the lower end portion of the left semi-circular cylinder portion 26a.

Therefore, the intermediate portion of the left semi-circular cylinder portion 26a is positioned in the cross-section (herein after called as the parallel cross-section.) which is parallel to the lower wall 12 of the casing 10 of the container body 20a. The upper portion of the left semi-circular cylinder portion 26a is positioned in the cross-section (herein after called as the upward inclined cross-section.) which is inclined by 45° upward relative to the center of the container body 20a with respect to the parallel cross-section of the container body 20a. The lower portion of the left semi-circular cylinder portion 26a is positioned in the cross-section (herein after called as the downward inclined cross-section.) which is inclined by 45° downward relative to the center of the container body 20a with respect to the parallel cross-section of the container body 20a.

The source gas introduction pipe group 20b includes a plurality (for example, 16) of source gas introduction pipes 23. The plurality of the source gas introduction pipes 23 are joined or bonded at respective base end opening portions 23a thereof by welding or the like to the upper portion of the left semi-circular cylinder portion 26a of the container body 20a with an equal interval in the front and rear direction so as to communicate with the interior of the container body 20a. Further, the plurality of the source gas introduction pipes 23 are extended leftward from their base end opening portions 23a through the upper portion of the left wall 13 of the casing 10.

The source gas introduction pipe group 20c includes a plurality (for example, 16) of source gas introduction pipes 24. The plurality of the source gas introduction pipes 24 are joined or bonded at respective base end opening portions 24a thereof by welding or the like to the intermediate portion of the left semi-circular cylinder portion 26a of the container body 20a with the above-mentioned equal interval in the front and rear direction so as to communicate with the interior of the container body 20a. Further, the plurality of the source gas introduction pipes 24 are extended leftward from their base end opening portions 24a through the intermediate portion of the left wall 13 of the casing 10.

The source gas introduction pipe group 20d includes a plurality (for example, 16) of source gas introduction pipes 25. The plurality of the source gas introduction pipes 25 are joined or bonded at respective base end opening portions 25a thereof by welding or the like to the lower portion of the left semi-circular cylinder portion 26a of the container body 20a with the above-mentioned equal interval in the front and rear direction so as to communicate with the interior of the container body 20a. Further, the plurality of the source gas introduction pipes 24 are extended leftward from their base end opening portions through the lower portion of the left wall 13 of the casing 10.

Additionally, the respective source gas introduction pipes 23, 24 and 25 of the source gas introduction pipe groups 20b to 20d corresponding to each other in the up and down direction are located at the same front and rear directional positions of the container body 20a.

In the first embodiment, upon maintaining the quantity and (or) speed in flow of the source gases within a predetermined range, the inner diameter of each source gas introduction pipe of the three sets of the source gas introduction pipe groups 20b to 20d is preferably predetermined to be a value within the range of 3 (mm) to 50 (mm). Furthermore, it is more preferable that the inner diameter of each source gas introduction pipe is predetermined to be a value within the range of 6 (mm) to 30 (mm).

In addition, the inner diameter of each source gas introduction pipe of the source gas introduction pipe groups 20b to 20d is predetermined to be 9 (mm). Further, Furthermore, in each of the source gas introduction pipe group 20b, 20b and 20d, the center interval of the respective both source gas introduction pipes adjacent to each other is predetermined to be 75 (mm).

The seal gas injection pipe group 20e serves to inject a seal gas (to be described later) from a seal gas supply source (not illustrated) into the container body 20a. As shown in Fig. 1 or 3, the seal gas injection pipe group 20e is extended leftward from the intermediate portion of the left semi-circular cylinder portion 26a of the container body 20a through the left wall 13 of the casing 10.

In the first embodiment, a chemically inert gas such as nitrogen, argon, helium or the like or a hydrogen gas is exemplified as the seal gas. This is based on the reason why it may be prevented that an extra or harmful influence is given on a reaction system by an oxygen gas which is mixed into the container body 20a from the outside or a nitrogen gas or the like which is introduced into the container body 20a from the outside. In the first embodiment, the hydrogen gas is adopted as the seal gas.

The seal gas injection pipe group 20e includes, for example, two seal gas injection pipes 27. The two seal gas injection pipes 27 are joined or bonded at their base end opening portions by welding or the like to the intermediate portion of the left semi-circular cylinder portion 26a of the container body 20a in both front and rear sides of the source gas introduction pipe group 20b so as to communicate with the interior of the container body 20a. Additionally, the respective seal gas injection pipes 27 are extended leftward from their base end opening portions through the intermediate portion of the left wall 13 of the casing 10.

The gas discharge pipe group 20f serves to discharge the gas inside the container body 20a to the outside of the container body 20a. As illustrated in Fig. 1, 4 or 6, the gas discharge pipe group 20f is extended rightward from the right semi-circular cylinder portion 26b of the container body 20a through the right wall 14 of the casing 10.

The gas discharge pipe group 20f includes, for example, five gas discharge pipes 28. The respective gas discharge pipes 28 are joined or bonded at their base end opening portions 28a by welding or the like to the intermediate portion of the right semi-circular cylinder portion 26b of the container body 20a with an equal interval in the front and rear direction so as to communicate with the interior of the container body 20a.

Herein, the intermediate portion of the right semi-circular cylinder portion 26b faces the intermediate portion of the left semi-circular cylinder portion 26a through the axis of the container body 20a in the front and rear direction. The respective gas discharge pipes 28 are extended rightward from their base end opening portions 28a through the intermediate portion of the right wall 14 of the casing 10 (corresponding to the intermediate portion of the left semi-circular cylinder portion 26a).

Additionally, the inner diameters of the respective gas discharge pipes 28 are equal to each other between the gas discharge pipes, but the sum of the inner diameters of the respective gas discharge pipes 28 is predetermined so as to ensure the cross-sectional area corresponding to the sum of the respective cross-sectional areas of the total source gas introduction pipes 23 to 25. This is based on the reason why the gas within the container body 20a is smoothly discharged.

In the first embodiment, the gas discharge pipe 28 positioned at the foremost end side of the container body 20a faces at its base end opening portion 28a the base end opening portion 24a of the third source gas introduction pipe 24 positioned in rear of the source gas introduction pipe 24 which is positioned at the foremost end side of the container body 20a. The gas discharge pipe 28 positioned at the rearmost end side of the container body 20a faces at its base end opening portion 28a the base end opening portion 24a of the third source gas introduction pipe 24 in front of the source gas introduction pipe 24 which is positioned at the rearmost end side of the container body 20a.

The cylindrical substrate 30 serves to grow a plurality of micro coils. The cylindrical substrate 30 is coaxially contained inside the container body 20a as described later. In addition, the cylindrical substrate 30 faces at its outer peripheral surface the base end opening portion of each source gas introduction pipe of the three sets of the source gas introduction pipe groups 20b to 20d of the container body 20a.

As illustrated in Fig. 1, 4 or 6, the cylindrical substrate 30 includes a cylindrical base body 31, a cylindrical catalyst layer 32 and both front and rear legs 33. The cylindrical base body 31 is formed with transparent quartz in a cylindrical shape. Sandblast processing is performed on the outer peripheral surface of the cylindrical base body 31.

The cylindrical catalyst layer 32 is formed in a cylindrical shape by coating powders of a metal catalyst with for example, a brush throughout the outer peripheral surface of the base body 31. Herein, since the sandblasting is performed on the outer peripheral surface of the cylindrical base body 31, as described above, the metal catalyst powders may be satisfactorily carried on the outer peripheral surface of the base body 31. This means that the cylindrical substrate 30 carries the powders of the metal catalyst in a cylindrical shape on the outer peripheral surface of the cylindrical base body 31 by the catalyst layer 32.

Herein, as the metal catalyst, may be exemplified at least one compound selected from oxide, carbide, sulfide, nitride, phosphide, carbonate, carbon sulfide or the like of transitional metal other than a single element of transitional metal such as nickel, iron, titanium, tungsten or the like or alloy.

The average particle diameter of each powder of the metal catalyst is a particle diameter within the range of 50 (nm) to 5 (µm). As the metal catalyst, may be more preferably exemplified metal such as nickel, titanium, tungsten, or the like, alloy, solid solution with oxygen, oxide, carbide, nitride, sulfide, phosphide, carbonate, carbon sulfide or the like. Among these, nickel and solid solution with oxygen are most preferable as the metal catalyst from the viewpoint of the anisotropy of the catalyst activity in each crystal face of the particles of the metal catalyst and cost.

When this will be described in detail, conventionally, one kind of metal among Ni, Fe, Nb, NiO and Au was adopted as the metal catalyst. In case pure metal such as Ni, Fe, Nb or the like was adopted as a catalyst, a considerable amount of largely wound carbon fibers or linear carbon fibers were also deposited other than the pure micro coils which are regularly wound. As the result, Only the micro coils of low coil purity were obtained. Further, in a case of a NiO catalyst, the coil yield amount or the coil purity was very low.

For winding into a coil shape a carbon fiber growing with vapor phase epitaxy or vapor phase growth from gaseous carbon species, it is necessary condition that the center portion of the catalyst is a single crystal and that there exists difference in the catalyst activity between the respective crystal faces, in other words, there exists the anisotropy in the catalyst activity.

For example, in a case of Ni, it is considered that the anisotropy is caused by a difference in the composition ratio of Ni-C-S-O-system four-component quasi-liquid phase (liquid phase) existing on a Ni single crystal face. This is caused by that for example, in the crystal faces of Ni (100), Ni (110) and Ni (111), the reactivity or adsorption capability with C, S and O in the respective crystal faces is different. In a case of NiO as Ni oxide, such an effect is small, and, thus, a ratio for forming the coil is also very low.

In order to sufficiently exhibit the anisotropy of the catalyst activity of the nickel catalyst, it is essential to perform a partial oxidization treatment and a partial sulfurization treatment on the surface of the nickel catalyst in advance. By this treatment, the anisotropy is extremely efficiently exhibited when the reaction is caused by introducing acetylene later, and hence micro coils efficiently grow. When the reaction is performed by directly introducing acetylene without performing the partial oxidization treatment and the partial sulfurization treatment, the anisotropy is not sufficiently exhibited, so that the coil yield rate and coil purity of the micro coils are extremely degraded.

For this reason, in the first embodiment, nickel and solid solution with oxygen are adopted as the metal catalyst. Specifically, powders of the nickel are subjected at their surfaces to a partial oxidization treatment and a partial sulfurization treatment, and thereafter form the solid solution with oxygen, thereby to coat it onto the base body 31 so as to have a thickness within the range of 2 (µm) to 5 (µm), thus obtaining the catalyst layer 32.

In the first embodiment, the base body 31 has an outer diameter within the range of 30 (mm) to 250 (mm). Herein, the outer diameter of the base body 31 is selected so that a predetermined facing gap in the radial direction of the base body 31 between the opening surface (the inner peripheral surface of the container body 20a) of the base end opening portion of each source gas introduction pipe of the three sets of the source gas introduction pipe groups 20b to 20d and the outer peripheral surface of the cylindrical substrate 30 (the outer peripheral surface of the catalyst layer 32) is predetermined to be a value within the range of 1 (mm) to 80 (mm). Further, the outer diameter of the base body 31 is selected so that the predetermined facing gap is more preferably predetermined to be a value within the range of 10 (mm) to 50 (mm) and that the predetermined facing gap is most preferably predetermined to be a value within the range of 15 (mm) to 30 (mm) .

As the predetermined facing gap becomes larger than 30 (mm), the ratio of regularly wound micro coils decreases, the coil diameter becomes largely irregular, and the ratio of largely curled micro coils gradually increases. When the predetermined facing gap becomes less than 1 (mm) or becomes larger than 100 (mm), any micro coil may not be completely obtained, and hence only the linear carbon fiber or carbon powder is deposited.

In the first embodiment, the predetermined facing gap in the radial direction of the base body 31 between the opening surface of the base end opening portion of each source gas introduction pipe of the three sets of the source gas introduction pipe groups 20b to 20d is predetermined to be 25 (mm), and the outer diameter of the base body 31 is predetermined to be 60 (mm).

As shown in Fig. 1, 4 or 6, both front and rear legs 33 are detachably extended at the same bifurcated shape thereof downward from both axially directional lower end portions of the catalyst layer 32. This means that the both front and rear legs 33 sit at their bifurcated portions on both front and rear directional lower portions of the inner peripheral surface of the container body 20a, thereby to coaxially support the base body 31 inside the container body 20a.

Both front and rear end covers 40 are respectively formed from transparent quartz in a longitudinally sectional U-shape by a wall portion 41 in the form of circular disk and an annular wall portion 42 which is extended from the outer periphery of the wall portion 41.

Accordingly, in both front and rear end covers 40, the front end cover 40 is air-tightly fitted detachably at the annular wall portion 42 to a axially directional front end portion 21 of the container body 20a through a front heat resistant O-ring 42a. The rear end cover 40 is air-tightly fitted at the annular wall portion 42 to an axially directional rear end portion 22 of the container body 20a through a rear heat resistant O-ring 42a.

In addition, the front heat resistant O-ring 42a is received in an annular groove portion which is formed on the axially directional intermediate portion of the annular wall portion 42 of the front end cover 40 from the inner surface side thereof. The rear heat resistant O-ring 42a is received in an annular groove portion which is formed on the axially directional intermediate portion of the annular wall portion 42 of the rear end cover 40 from the inner surface side thereof.

As illustrated in Fig. 2, the heating circuit E includes a heater 50, a temperature sensor 60 and a temperature controller 70. The heater 50 includes a plurality of heating wire members 51. The plurality of heating wire members 51 are respectively formed by bending a predetermined length of each nichrome wire in a U-shape with both parallel wire portions 51a and 51b to each other and a connection wire portion 51c connecting both parallel wire portions 51a and 51b.

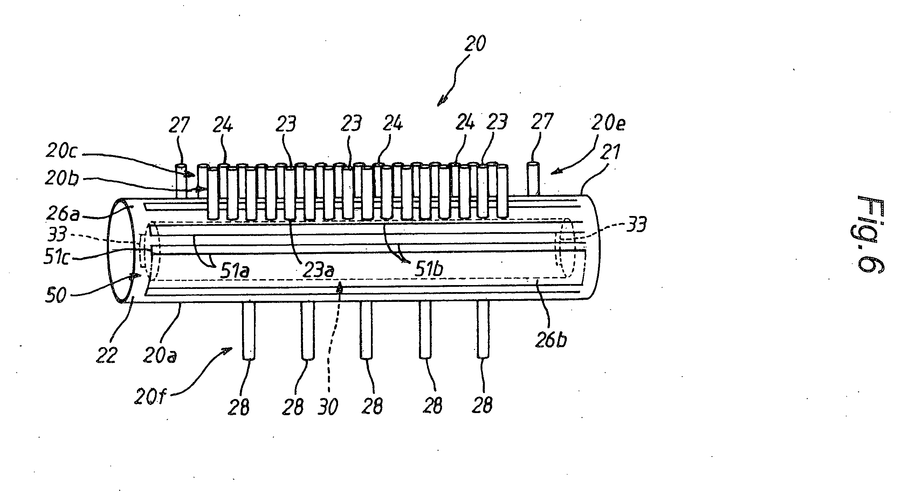

The plurality of heating wire members 51 with such a construction are, as illustrated in Fig. 6, arranged at an equally angular interval along the outer peripheral surface of the container body 20a in its circumferential direction. Herein, each of the plurality of heating wire members 51 is arranged at its connection wire portion 51c so as to be positioned at the rear side of the container body 20a and to be extended at both parallel wire portions 51a and 51b along the front and rear direction of the container body 20a. Accordingly, the plurality of heating wire members 51 of the heater 50 are arranged so as to be substantially distributed over the entire container body 20a.

In the heater 50 which is arranged in this way, the plurality of the heating wire members 51 are connected at the connection end portion of the respective parallel wire portions 51a to each other and are connected at the connection end portion of the respective parallel wire portions 51b to each other. Accordingly, the heater 50 heats the substantially entire outer peripheral surface of the container body 20a by the heating of the respective heating wire members 51.

The temperature sensor 60 is formed by a thermocouple of a high temperature detection type. As illustrated in Fig. 1 or 5, the temperature sensor 60 is supported by the center portion inside the hollow portion of the cylindrical substrate 30. Herein, the center portion inside the hollow portion corresponds to the front and rear directional center portion of the hollow portion of the cylindrical substrate 30 and the radial directional center portion of the same. Accordingly, the temperature sensor 60 detects the temperature at the center portion inside the hollow portion of the cylindrical substrate 30 as the temperature of the container body 20a.

The temperature controller 70 is constructed by an inverter. The temperature controller 70 is supplied with an alternating current voltage (hereinafter called as AC voltage.) of 200 (V) from an alternating current power supply PS (hereinafter called as AC power supply PS.) through an operating switch SW to control the heater 50 so as to generate heat at the respective heating wire members 51 on the basis of a temperature detected by the temperature sensor 60. Herein, this control is performed so as to maintain the container body 20a at a predetermined high temperature on the basis of the detected temperature of the temperature sensor 60. This means to maintain the interior of the container body 20a at the above-mentioned predetermined high temperature.

In the embodiment, the predetermined high temperature is preferably determined to be a temperature within the range of 600 (°C) to 950 (°C) from the viewpoint of the yield amount and yield rate of the micro coils. And it is more preferable that the predetermined high temperature is determined to be a temperature within the range of 700 (°C) to 800 (°C). In the first embodiment, the predetermined high temperature is, therefore, determined to be a temperature of 750 (°C). In addition, when the predetermined high temperature is less than 600 (°C) or higher than 950 (°C), most of micro coils do not grow up.

In the first embodiment with the above-described construction, micro coils are manufactured in a vapor phase by the manufacturing apparatus as follows. Additionally, in the vapor phase manufacturing process, the temperature sensor 60 detects a temperature within the center portion of the hollow portion of the cylindrical substrate 30 as the temperature of the container body 20a.

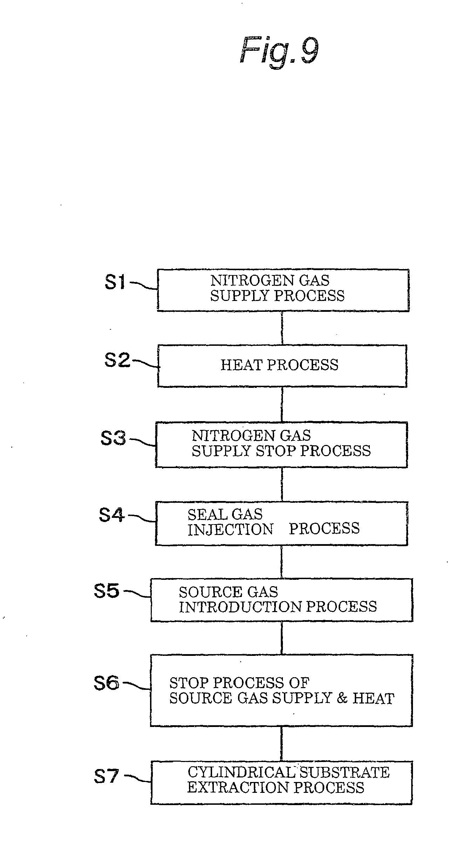

As shown in a manufacturing process of Fig. 9, first, a nitrogen gas supply process S1 is performed. In the nitrogen gas supply process S1, a nitrogen gas is supplied from a nitrogen gas supply source (not shown) at a flow quantity of 1000 (ml/minute) into the container body 20a of the reaction container 20 through the entire source gas introduction pipes of the source gas introduction pipe group 20b.

Accordingly, the nitrogen gas supplied into the container body 20a flows inside the container body 20a and is discharged from the gas discharge pipe group 20f so as to press gases such as oxygen and the like in the container body 20a outward. Accordingly, degassing and deoxygenation treatments in the interior of the reaction container 20 including the container body 20a may be performed.

Further, a heat treatment of the container body 20a is performed in a heat process S2 in accordance with the nitrogen gas supply process S1 or after the nitrogen gas supply process S1. In the heat treatment, the temperature controller 70 is supplied with the AC voltage from the AC power supply PS under closing of the operating switch SW and is conditioned in operation to control the heater 50 on the basis of the currently detected temperature of the temperature sensor 60 so as to generate heat therefrom.

Accordingly, the respective heating wire members 51 heat the container body 20a so as to increase a temperature of the container body 20a up to the predetermined high temperature. Further, even if the temperature of the container body 20a changes after the temperature of the container body 20a reaches the predetermined high temperature of 750 (°C), the temperature controller 70 controls the heater 50 on the basis of the later detected temperature of the temperature sensor 60 in such a manner to maintain the temperature of the container body 20a at the predetermined high temperature of 750 (°C). Thus, the interior of the container body 20a is maintained at the predetermined high temperature of 750 (°C).

After the heat process S2 is performed in this way, at a nitrogen gas supply stop process S3, the supply of the nitrogen gas from the nitrogen gas supply source into the container body 20a is stopped.

Subsequently, at a next seal gas injection process S4, a hydrogen gas which is a seal gas is injected into the container body 20a at 1000 (ml/minute) through the respective seal gas injection pipes 27 of the seal gas injection pipe group 20e. Accordingly, the nitrogen gas which was supplied previously into the container body 20a is discharged from the respective discharge pipes 28 of the gas discharge pipe group 20f by the seal gas injected into the container body 20a.

For this reason, atmosphere in the interior of the container body 20a becomes only the hydrogen gas, which is the seal gas, together with atmosphere in the interior of the cylindrical substrate 30. Accordingly, it may be prevented that an extra or harmful influence is given to the reaction system in the interior of the container body 20a together with the interior of the cylindrical substrate 30.

Thus, even if the source gases are introduced into the container body 20a at a source gas introduction process S5 as described below, the nitrogen gas is not mixed with the source gases. As a result, it is possible to prevent in advance a generation of a situation that the nitrogen gas inhibits the thermal decomposition reaction of acetylene included in the source gases, thereby to prevent in advance degradation in the coil yield amount of micro coils and the coil purity (to be described later) of the micro coils.

When the seal gas injection process S4 is ended as described above, at the next source gas introduction process S5, the source gases supplied from the source gas supply source, that is, the mixture gas of the acetylene gas, the hydrogen gas and the hydrogen surfide gas is introduced into the container body 20a from the left side thereof through the respective source gas introduction pipes of the three sets of the source gas introduction pipe groups 20b to 20d.

At the present stage, the interior of the container body 20a is maintained at the predetermined high temperature together with the outer peripheral surface of the cylindrical substrate 30 and the interior thereof. This means that the outer peripheral surface of the catalyst layer 32 is also maintained at the predetermined high temperature.

In such a state, when the source gases are introduced into the container body 20a as described above, a reaction is initiated between the source gases and the metal catalyst of the catalyst layer 32. This means that the source gas introduction process S5 is a reaction process. Additionally, in the first embodiment, the reaction time at the reaction process is predetermined to be 2 hours.

Herein, the source gases for each source gas introduction pipe include the acetylene gas of 60 (ml/minute), the hydrogen gas of 265 (ml/minute) and the hydrogen surfide gas of 0.06 (ml/minute).

Accordingly, the source gases inside the source gas supply source are uniformly mixed in advance so as to become the mixture gas of the acetylene gas of 60 ml/minute, the hydrogen gas of 265 ml/minute and the hydrogen sulfide gas of 0.06 ml/minute per the introduction pipe.

Herein, the reason why the source gases are composed of the acetylene gas, the hydrogen gas and the hydrogen sulfide gas, as described above is as follows.

Conventionally, the source gases were simultaneously and continuously introduced into the container body 20a and then reacted with a catalyst as a mixture gas composed of an acetylene gas, a hydrogen gas, a nitrogen gas, a thiophene gas and a hydrogen sulfide gas.

However, the nitrogen gas causes not only suppressing the thermal decomposition of acetylene noticeably but also causes a harmful side reaction, thereby to prevent the growth of the regularly wound micro coils and to degrade the coil yield amount and the coil purity. Further, the thiophene gives a harmful influence on the growth of the regularly wound micro coils, which causes degradation in the coil yield amount and the coil purity.

In the first embodiment, the source gases are, therefore, predetermined or constructed as the mixture gas composed of the acetylene gas, the hydrogen gas and the hydrogen sulfide gas, as described above. Additionally, when the source gases are thermally decomposed as described below, gaseous carbon species are generated from the outer peripheral surface of the cylindrical substrate 30.

Showing the flow quantity of the source gases introduced into the container body 20a through the respective source gas introduction pipes of the three sets of the source gas introduction pipe groups 20b to 20d with the linear velocity of the gases, it is preferable that the linear velocity of the gases is predetermined to be a value within the range of 100 (cm/min) to 3000 (cm/min) under the condition of a room temperature and 1 atm in order to improve the yield amount of the micro coils and the yield rate of the micro coils. It is more preferable that the linear velocity of the gases is predetermined to be a value within the range of 200 (cm/min) to 2000 (cm/min). Further, it is particularly preferable that the linear velocity of the gases is predetermined to be a value within the range of 500 (cm/min) to 1500 (cm/min).

In the first embodiment, the linear velocity of the gases is, therefore, predetermined to be a value within the range of 500 (cm/min) to 1500 (cm/min). Further, the linear velocity of the gases has a close relation with a gap (hereinafter called as a predetermined facing gap.) between the base end opening portion of the source gas introduction pipe and the portion of the outer peripheral surface of the cylindrical substrate 30 facing the base end opening portion of the source gas introduction pipe. For this reason, when the linear velocity of the gases is a value within the range of, for example, 500 (cm/min) to 800 (cm/min), it is preferable that the predetermined facing gap is predetermined to be a value within the range of 10 (mm) to 20 (mm) .

Initiating the reaction between the source gases and the metal catalyst of the catalyst layer 32, as described above, micro coils grow densely in a circle having a diameter within the range of two to thirty times the inner diameter of the source gas introduction pipe in a facing surface portion of the cylindrical outer peripheral surface of the base body 31 of the cylindrical substrate 30 to the base end opening portion of each source gas introduction pipe of the three sets of the source gas introduction pipe groups 20b to 20d.

For this reason, the gap between both adjacent introduction pipes among the respective source gas introduction pipes of the three sets of the source gas introduction pipe groups 20b to 20d is preferably predetermined to be a value within the range of two to thirty times the inner diameter of the source gas introduction pipe in order to grow the respective micro coils on the outer peripheral surface of the cylindrical substrate 30 without any interference and clearance to each other. It is more preferable that the above-mentioned gap is predetermined to be a value within the range of five to twenty times the inner diameter of the source gas introduction pipe.

Therefore, in the first embodiment, the gap between both adjacent source gas introduction pipes is predetermined to be a value (75 (mm)) within the range of five to twenty times the inner diameter (9 (mm)) of the source gas introduction pipe.

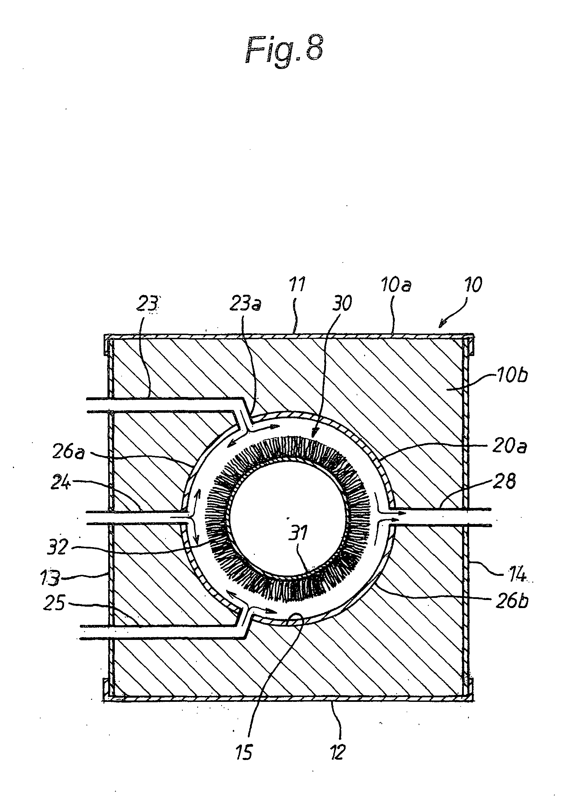

Accordingly, the respective micro coils can grow on the surface of the cylindrical substrate 30 to the base end opening portions of the respective source gas introduction pipes of the three sets of the source gas introduction pipe groups 20b to 20d with a substantially uniform thickness almost without any overlapping or superposing to each other (see Fig. 8). This means that many micro coils are manufactured by growing on the cylindrical substrate 30.

When the source gas introduction process S5 is ended, as described above, at a next stop process S6 of source gas supply and heat, the supply of the source gases from the source gas supply source into the container body 20a is stopped and the control of the heater 50 by the temperature controller 70 is stopped. Specifically, the operating switch SW is opened. Accordingly, the reaction between the source gases and the metal catalyst of the catalyst layer 32 is ended.

Thereafter, at a cylindrical substrate extraction process S7, when the temperature inside the container body 20a falls to 200 (°C) with the above-mentioned stop of the control of the heater 50, both front and rear end covers 40 of the main body B are separated from both end portions of the container body 20a, and then the cylindrical substrate 30 is extracted from the interior of the container body 20a. Subsequently, the micro coils growing on the cylindrical substrate 30 is collected.

As described above, according to the first embodiment, the three sets of the source gas introduction pipe groups 20b to 20d in the reaction container 20 are extended leftward from the left semi-circular cylinder portion 26a of the container body 20a, and the gas discharge pipe group 20f is extended rightward from the right semi-circular cylinder portion 26b of the container body 20a. Further, in the cylindrical substrate 30 inserted into the container body 20a, a partial oxidization treatment and a partial sulfurization treatment are performed on the surface of the nickel catalyst so as to deposit or precipitate micro coils. Then, the nickel catalyst as previously performed is coated on the outer peripheral surface of the cylindrical base body 31 thereby to be formed as the catalyst layer 32.

Under such a construction, the source gases obtained by mixing the acetylene gas, the hydrogen gas and the hydrogen surfide gas are simultaneously and continuously introduced into the container body 20a under a state in which the container body 20a is heated and maintained at the predetermined high temperature of 750 (°C). Thus, micro coils grow on the outer peripheral surface of the cylindrical substrate 30, as described above.

As a result of collecting the micro coils growing in this way as described above, the coil yield amount of the collected micro coils was 60 (g). Further, the coil yield rate of the acetylene-based micro coils was 80 (%). This means that a large amount of the micro coils can be manufactured efficiently with high purity at one time. In addition, the micro coils manufactured in this way may be utilized for an electromagnetic wave absorption material, a micro wave heat generating material, a micro sensor, a micro mechanical element, a healing or relaxational material, cosmetics, an analgesic material, a cancer treatment medicine, a food additive, and the like.

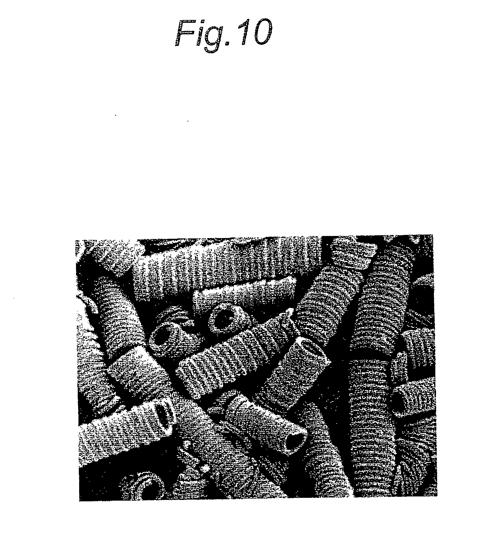

Incidentally, according to an electron micrograph (a photograph by an electron microscope (SEM)) of the precipitates obtained in the first embodiment, the growing precipitates include 100 (%) of micro coils (carbon micro coils), as shown in Fig. 10. Most of the micro coils are regularly wound with the coil diameter within the range of 3 (µm) to 5 (µm). Further, there is almost no gap between the adjacent coil portions of each micro coil. Thus, each micro coil becomes an electromagnetic micro or minute solenoid shape.

In other words, in the precipitates, the ratio or percentage of the solenoid-shaped micro coil wound regularly with a constant coil diameter, that is, the coil purity is 100 (%).

Furthermore, according to the manufacturing apparatus mentioned in the first embodiment, in the reaction container 20, the respective source gas introduction pipes of the three sets of the source gas introduction pipe groups 20b to 20d and the respective gas discharge pipes of the gas discharge pipe group 20f are horizontally extended from the casing 10 so as to be parallel to the horizontal plane L of the base from both left and right side walls 26a and 26b of the container body 20a toward the opposite directions to each other.

Accordingly, the source gases are introduced into the container body 20a along the horizontal plane L of the base through each source gas introduction pipe. Thus, the source gases introduced into the container body 20a in this way flow smoothly and satisfactorily along the outer peripheral surface of the cylindrical substrate 30 toward the lateral or left and right direction inside the container body 20a. As a result, the reaction between the source gases and the catalyst of the cylindrical catalyst layer 32 of the cylindrical substrate 30 can be satisfactorily performed without any limitation. Further, the gases inside the container body 20a are discharged along the horizontal plane L of the base through each discharge pipe 28. Thus, discharge of the gases can be smoothly performed.

As a result, the thermal decomposition reaction and catalyst reaction between the source gases and the catalyst sufficiently occur inside the container body 20a, thereby to increase the yield amount and purity of the micro coils so much.

Further, each source gas introduction pipe and each gas discharge pipe are extended horizontally from the casing 10 so as to be parallel to the horizontal plane L of the base as described above. Thus, upon preparing the plurality of the main bodies B mentioned in the first embodiment to layering or stacking each casing 10 of the main bodies B upward, it is possible to easily stack these plurality of the main bodies B without causing interference with the three sets of the source gas introduction pipe groups 20b to 20d and the gas discharge pipe group 20f.

With the above-described construction, it is possible to increase the coil yield amount and coil yield rate of the micro coils in accordance with the number of the stacked main bodies B and also to decrease the installation area of the plurality of main bodies B inside a factory or the like so as to increase the use efficiency inside the factory or the like.

Next, the main body B of the first embodiment was prepared as a working example 1-1, and a working example 1-2 and comparative examples 1-1 to 1-7 were also prepared for the comparison with the working example 1-1. In addition, the heating circuits of the working example 1-2 and the comparative examples 1-1 to 1-7 were the same as the heating circuit E of the first embodiment.

### (Working example 1-2)

In the main body of the working example 1-2, a catalyst layer (hereinafter called as a nickel catalyst layer.) which was formed from nickel and oxidized partially at its surface was adopted as the catalyst layer 32 of the cylindrical substrate 30. The other constructions of the main body of the working example 1-2 were the same of the main body B of the working example 1-1.

For manufacturing micro coils using the working example 1-2, in the manufacturing process mentioned in the first embodiment, prior to the source gas introduction process S5, only hydrogen sulfide was introduced into the container body 20a for five minutes through the respective source gas introduction pipes of the three sets of the source gas introduction pipe groups 20b to 20d.

Then, at the heat process S5, the partial sulfurization treatment was performed on the surface of the above-mentioned nickel catalyst layer inside the container body 20a maintained at 750 (°C) at the heat process S2. Thereafter, at the source gas introduction process S5, acetylene was introduced into the container body 20a through the respective source gas introduction pipes so as to perform a reaction with the nickel catalyst layer. The other processes were the same as those mentioned in the first embodiment.

According to the working example 1-2, the coil yield amount of the micro coils was 58 (g), the coil yield rate of the micro coils was 78 (%), and the coil purity of the micro coils was 100 (%) . Thus, it may be understood that even in the working example 1-2, the same manufacturing result as that of the working example 1-1 was substantially obtained.

Further, as the same in the working example 1-1 even in the working example 1-2, in the reaction container 20 the three sets of the source gas introduction pipe groups 20b to 20d and the gas discharge pipe group 20f are extended horizontally from the casing 10 so as to be parallel to the horizontal plane L of the base from both left and right cylindrical wall portions 26a and 26b of the container body 20a toward the opposite directions to each other.

Accordingly, when preparing the plurality of main bodies of the working example 1-2 and stacking the plurality of main bodies upward at each casing 10, it is possible to easily stack the plurality of main bodies without causing interference with the respective source gas introduction pipe groups 20b to 20d and the gas discharge pipe group 20f. Thus, even in the working example 1-2, it is possible to increase the coil yield amount and coil yield rate of the micro coils in accordance with the number of the stacked main bodies.

### (Comparative example 1-1)

In the main body of the comparative example 1-1, the predetermined facing gap along the radial direction of the base body 31 which was formed between the opening surface of the base end opening portion of each source gas introduction pipe of the three sets of the source gas introduction pipe groups 20b to 20d and the outer peripheral surface of the cylindrical substrate 30 was predetermined to be set to 60 (mm). The other constructions of the main body of the comparative example 1-1 were the same as those of the working example 1-1.

By using the main body of the comparative example 1-1, the micro coils were manufactured as the same as the micro coils of the working example 1-1 according to the manufacturing process of the first embodiment.

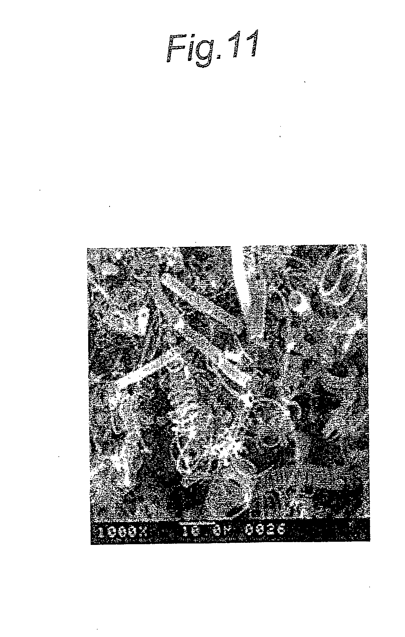

According to another electron micrograph (another photograph by SEM) of the precipitates obtained in this way, micro coils wound irregularly and micro coils with a coil diameter of 10 (µm) or more and with a coil-shape collapsed largely were observed a lot other than micro coils wound regularly with a coil diameter within the range of 3 (µm) to 5 (µm), as illustrated in the example of Fig. 11. In addition, a small amount of linear carbon fibers was also observed.

Thus, according to the comparative example 1-1, the coil yield amount and coil purity of the micro coils were lower than those of the working example 1-1.

### (Comparative example 1-2)

In the main body of the comparative example 1-2, the predetermined facing gap along the radial direction of the base body 31 between the opening surface of the base end opening portion of each source gas introduction pipe of the three sets of the source gas introduction pipe groups 20b to 20d and the outer peripheral surface of the cylindrical substrate 30 was predetermined to be 80 (mm). The other constructions of the main body of the comparative example 1-2 were the same as those of the main body B of the working Example 1-1.

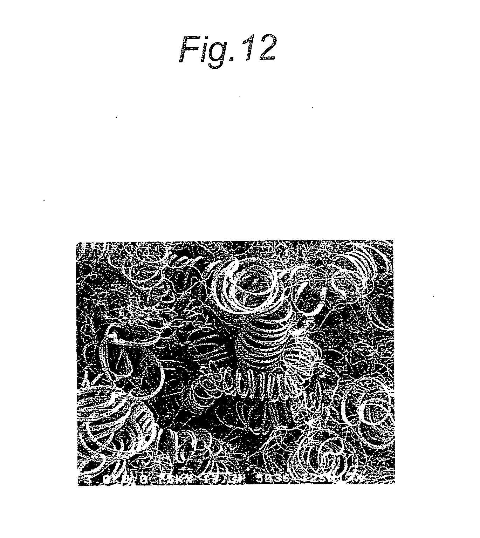

By using the main body of the comparative example 1-2, micro coils were manufactured as the same as the micro coils manufactured by the working example 1-1 according to the manufacturing process of the first embodiment. According to still another electron micrograph (still another photograph by SEM) of the precipitates obtained in this way, most of coils were extremely irregularly wound or largely irregularly wound, and linear carbon fibers were included in the precipitates, as illustrated exemplarily in Fig. 12. As the result, any micro coil was not observed.

### (Comparative example 1-3)

In the main body of the comparative example 1-3, as the catalyst layer 32 of the cylindrical substrate 30, was adopted a nickel catalyst layer which was formed from nickel, was oxidized partially at its surface and had an average thickness of 0.5 (µm). The other constructions of the main body of the comparative Example 1-3 were the same as those of the main body B of the working example 1-1.

According to the comparative example 1-3, the coil yield amount of micro coils was very low and only 5 (g). In addition, most of the precipitates by the comparative example 1-3 were linear carbon fibers.

### (Comparative example 1-4)

In the main body of the comparative example 1-4, was adopted as the catalyst layer 32 of the cylindrical substrate 30 a nickel catalyst layer which was formed from nickel, was oxidized partially at its surface and had an average thickness of 15 (µm). The other constructions of the main body of the comparative example 1-4 were the same as those of the main body B of the working example 1-1.

By using the comparative example 1-4, the manufacturing process mentioned in the first embodiment was adopted so as to manufacture micro coils. In this case, the temperature inside the container body 20a rose abruptly with the initiation of the reaction at the source gas introduction process S5. When one minute lapsed thereafter, the temperature of the outer peripheral surface (the surface of the catalyst layer) of the cylindrical substrate 30 rose to 850 (°C) or more, and the temperature of the position apart from the outer peripheral surface of the cylindrical substrate 30 by 10 (mm) rose up to 820 (°C) at maximum.

Furthermore, a rigid carbon layer with a thickness within the range of 1.5 (mm) to 3 (mm) was deposited on the outer peripheral surface of the cylindrical substrate 30. In the precipitates, the coil yield rate of micro coils was only 10 (g). Additionally, in the precipitates, regularly wound coils were very few, and most of coils were very irregularly wound coils, largely wound coils or linear carbon fibers.

### (Comparative example 1-5)

In the main body of the comparative example 1-5, a catalyst layer which was formed from pure nickel powders without any oxygen was adopted as the catalyst layer 32 of the cylindrical substrate 30. The other constructions of the main body of the comparative example 1-5 are the same as those of the main body B mentioned in the working example 1-1.

By using the comparative example 1-5, the manufacturing process mentioned in the first embodiment was adopted so as to manufacture micro coils. In this case, the coil yield amount of micro coils was only 15 (g), and the coil purity of the micro coils was as low as a value within the range of 30 (%) to 35 (%).

### (Comparative example 1-6)

In the main body of thecomparative example 1-6, a catalyst layer formed from oxidized nickel is adopted as the catalyst layer 32 of the cylindrical substrate 30. The other constructions of the main body of the comparative example 1-6 are the same as those of the main body B mentioned in the working example 1-1.

By using the comparative example 1-6, the manufacturing process mentioned in the first embodiment was adopted so as to manufacture micro coils. In this case, the coil yield amount of micro coils was only 10 (g), and the coil purity of the micro coils was as low as a value within the range of 10 % to 20 %. (Comparative Example 1-7)

The main body of the comparative example 1-7 was the same as the main body B of the working example 1-1. For manufacturing micro coils by using the comparative example 1-7 according to the manufacturing process mentioned in the first embodiment, the source gases included an acetylene gas of 50 ml/minute, a hydrogen gas of 200 ml/minute and a hydrogen sulfide gas of 0.06 ml/minute per a source gas introduction pipe, and were simultaneously and continuously introduced into the container body together with a nitrogen gas of 200 ml/minute. The other manufacturing constructions were the same as those by the working example 1-1.

According to the comparative example 1-7, the coil yield amount of micro coils was very low and only 12 g, and the coil purity of the micro coils was only 25 %.

Incidentally, upon manufacturing micro coils, the precipitates obtained by the conventional manufacturing method or apparatus included coils wound irregularly, coils with a large coil diameter, carbon fibers wound largely and linear carbon fibers in a large number other than electromagnetic solenoid-shaped high-quality micro coils which are regularly wound at a constant coil pitch and a constant coil diameter. In this case, the ratio of the solenoid-shaped high-quality micro coils in the entire precipitates (hereinafter, referred to as the "coil purity") was as low as a value within the range of 5 (%) to 25 (%). By that the coil purity is low in this way, a bad influence is given to many characteristics such as an electromagnetic wave absorption characteristic of a microwave and so on. Accordingly, it is required that from the industrial viewpoint, the coil purity of the micro coils is 80 (%) or more.

From this point, the coil purity of the micro coils manufactured using each main body of the working examples 1-1 and 1-2 was 100 (%), as previously described. This means that the coil purity is enough.

Next, a second embodiment of the manufacturing apparatus of micro coils according to the present invention will be described. In the second embodiment, the reaction container 20 of the main body B of the manufacturing apparatus mentioned in the first embodiment is constructed in relation with the casing 10 as follows, differing from the first embodiment.

The three sets of the source gas introduction pipe groups 20b to 20d and the seal gas injection pipe group 20e which are mentioned in the first embodiment are extended downward from the lower semi-circular cylinder portion of the container body 20a of the reaction container 20. Meanwhile, the gas discharge pipe group 20f mentioned in the first embodiment is extended upward from the upper semi-circular cylinder portion of the container body 20a.

Specifically, in the second embodiment, the reaction container 20 (see Fig. 6) mentioned in the first embodiment is rotated by 90°, thereby to locate the three sets of the source gas introduction pipe groups 20b to 20d and the seal gas injection pipe group 20e under side of the container body 20a and to locate the gas discharge pipe group 20f upper side of the container body 20a.

Accordingly, the respective plurality of the source gas introduction pipes 23, 24 and 25 are extended downwardly from the left portion, the intermediate portion (the lower end portion) and the right portion of the lower semi-circular cylinder portion of the container body 20a, and both of the seal gas injection pipes 27 are extended downwardly from the intermediate portion of the lower semi-circular cylinder portion of the container body 20a.

Further, each gas discharge pipe 28 is extended upwardly from the intermediate portion (the upper end portion) of the upper semi-circular cylinder portion of the container body 20a. The other constructions are the same as those of the first embodiment.

In the second embodiment with such a construction, micro coils are manufactured by the gas-phase growth or vapor-phase epitaxy according to the manufacturing process mentioned in the first embodiment. At the source gas introduction process S5 of the manufacturing process, the source gases supplied from the source gas supply source are introduced into the container body 20a from the lower side thereof through the respective source gas introduction pipes of the three sets of the source gas introduction pipe groups 20b to 20d. In addition, the gases in the container body 20a are discharged upwardly from the interior of the container body 20a through each gas discharge pipe 28. The processing of the other manufacturing process are the same as those of the first embodiment.

With regard to the micro coils manufactured according to such a manufacturing process, the coil yield amount was 65 (g), the coil yield rate was 88 (%), and the coil purity was 100 (%).

Thus, with the second embodiment, it is possible to obtain the substantially same manufacturing results as those of the manufacturing apparatus mentioned in the first embodiment.

In the second embodiment, differing from the first embodiment, the respective source gas introduction pipes 23 to 25 are extended downwardly from the container body 20, and the respective gas discharge pipes 28 are extended toward the upside of the container body 20a.

Accordingly, the source gases are introduced into the container body 20a upwardly through the respective source gas introduction pipes. Thus, the source gases smoothly and satisfactorily flow upwardly along the outer peripheral surface of the cylindrical substrate 30 in the container body 20a. As the result, the reaction of the source gases with the catalyst of the cylindrical catalyst layer 32 of the cylindrical substrate 30 can be satisfactorily performed without any limitation. Furthermore, the gases in the container body 20a are discharged upwardly through the respective discharge pipes 28. Thus, the discharge of the gases can be smoothly performed.

As the result, the thermal decomposition reaction and the catalyst reaction occur sufficiently between the source gases and the catalyst in the container body 20a, so that the yield amount and the purity of the micro coils can be increased so much.

In addition, each source gas introduction pipe is extended downwardly from the container body 20a and each gas discharge pipe is extended upwardly from the container body 20a, as described above. Thus, even if the plural main bodies of the second embodiment are prepared, the main bodies cannot be stacked due to the disturbance by each source gas introduction pipe and each gas discharge pipe. For this reason, it is difficult to ensure increase of the coil yield amount and the coil yield rate of the micro coils which may be expected in case of stacking the main bodies of the first embodiment. The other operation and effect are the same as those of the first embodiment.

Incidentally, the main body of the second embodiment was set as a working example 2-1, and comparative examples 2-2 and 2-3 were prepared for the comparison with the working example 2-1.

### (Comparative example 2-2)

In a reaction container of the main body of the comparative example 2-2, adopted is a construction that each source gas introduction pipe is extended upwardly from the upper portion of the container body so as to extend each gas discharge pipe downwardly from the lower portion of the container body, differing from the reaction container of the main body of the working example 2-1.

With this construction, the source gases are introduced into the container body upwardly from each source gas introduction pipe so as to discharge the gases in the container body upwardly from each gas discharge pipe. The other constructions of the main body of the comparative example 2-2 are the same as those of the working example 2-1.

According to the comparative example 2-2, with regard to micro coils, the coil yield amount was 15 (g), and the coil purity was a value within the range of 20 (%) to 30 (%). Thus, with the comparative example 2-2, it can be understood that the coil yield amount and the coil purity of micro coils are considerably lower in comparison with than any one of the working examples 1-1, 1-2 and 2-1.

Furthermore, even if the plural main bodies of the comparative example 2-2 are prepared, the stacking of these main bodies is disturbed by each source gas introduction pipe and each gas discharge pipe. Thus, it is impossible to stack the plural main bodies of the comparative example 2-2 as the same as in the stacking case of the working example 2-1. For this reason, it is not possible to ensure increase of the coil yield amount and the coil yield rate of micro coils which may be expected in case of stacking the main bodies of the working example 1-1 or 1-2 of the first embodiment.

### (Comparative example 2-3)

The main body of the comparative example 2-3 is the same as the main body of the comparative example 2-2. For manufacturing micro coils by using the comparative example 2-3 according to the manufacturing process mentioned in the first embodiment, a nitrogen gas of 200 (ml/minute) and a thiophene gas of 0.20 (ml/minute) were simultaneously and continuously introduced into the container body with the source gases including an acetylene gas of 50 (ml/minute), a hydrogen gas of 200 (ml/minute) and a hydrogen surfide gas of 0.06 (ml/minute) per each source gas introduction pipe. The other manufacturing constructions were the same as those of the comparative example 2-2.

According to the comparative example 2-3, the coil yield amount of the micro coils was extremely little or small and only 15 (g). And the coil purity of the micro coils was also low and only 20 (%).

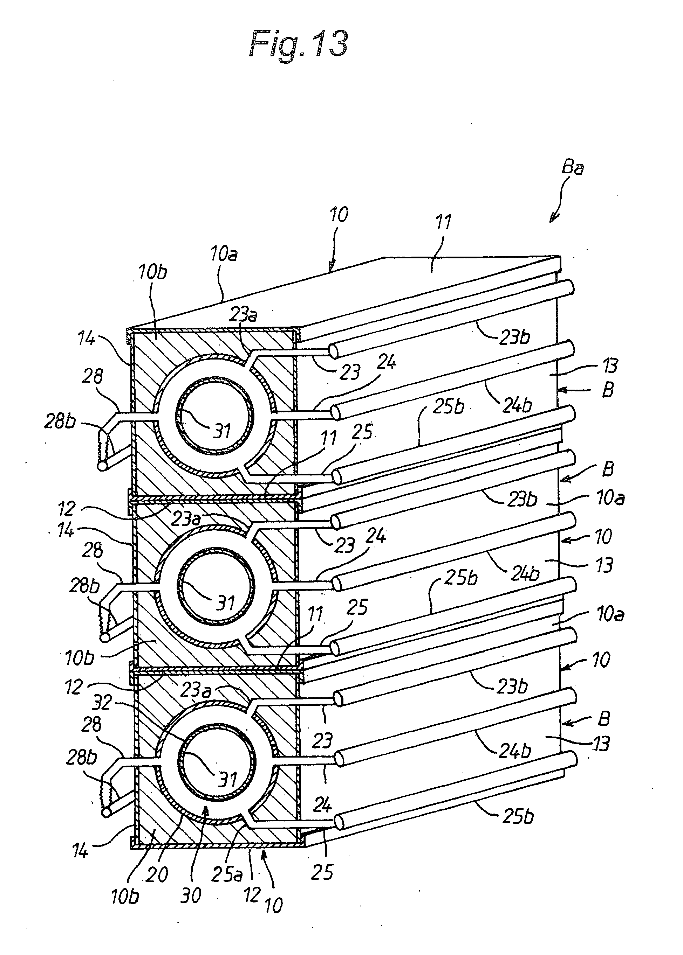

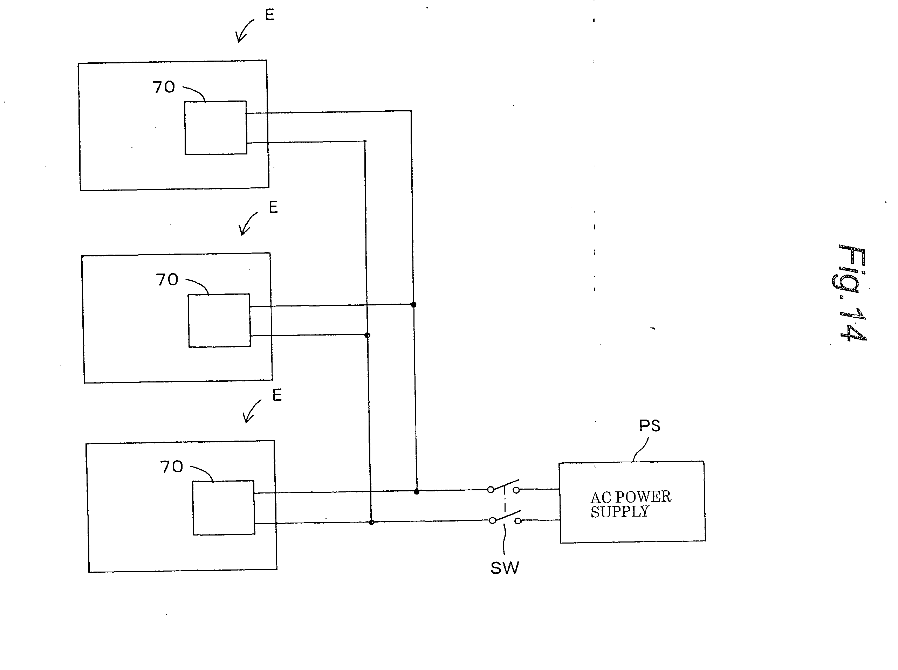

Figs. 13 and 14 illustrate a third embodiment of manufacturing apparatus of the micro coil according to the present invention. In the third embodiment, a stacked main body Ba is, as illustrated in Fig. 13, adopted as a substitute for the main body B of the manufacturing apparatus mentioned in the first embodiment.

The stacked main body Ba is constructed by stacking a plurality (for example, three) of the main bodies B mentioned in the first embodiment. Among the three main bodies B, the lower main body B is placed at the lower wall 12 of the casing 10 on the horizontal plane L (see Fig. 1) of the base.

Further, among the three main bodies B, the intermediate main body B is placed at the lower wall 12 of the casing 10 on the upper wall 11 of the casing 10 of the lower main body B, and the upper main body B is placed at the lower wall 12 of the casing 10 on the upper wall 11 of the casing 10 of the intermediate main body B.

In the source gas introduction pipe groups 20b to 20d of each reaction container 20 of the three main bodies B in the third embodiment, the respective source gas introduction pipes 23 constructing the source gas introduction pipe group 20b are connected to each other by a connection pipe 23b, the respective source gas introduction pipes 24 constructing the source gas introduction pipe group 20c are connected to each other by a connection pipe 24b, and the respective source gas introduction pipes 25 constructing the source gas introduction pipe group 20d are connected to each other by a connection pipe 25b. Accordingly, the source gases from the source gas supply source are introduced into each container body 20a through the connection pipes 23b, 24b and 25b and the respective source gas introduction pipes of the three sets of the source gas introduction pipe groups 20b to 20d.

The respective gas discharge pipes 28 constructing the gas discharge pipe group 20f of each reaction container 20 of the three main bodies B are connected to each other by a connection pipe 28b. Accordingly, gases within each container body 20a are discharged through the respective gas discharge pipes 28 and the connection pipe 28b. The other constructions of each main body B of the stacked main body Ba are the same as those of the first embodiment.

A heating circuit of the third embodiment is, as shown in Fig. 14, constructed by adopting the heating circuit E mentioned in the first embodiment for each main body B of the stacked main body Ba. Herein, the respective heating circuits E are together connected at their temperature controllers 70 to the AC power supply PS through the operating switch SW.

Accordingly, in each main body B of the stacked main body Ba, the heating circuit E is supplied with at its temperature controller 70 the AC voltage from the AC power supply PS through the operating switch SW, thereby to drive the corresponding heater 50 on a basis of the detected output of the corresponding temperature sensor 60 and to control the corresponding heater 50 so as to maintain the temperature of the corresponding container body 20a at the predetermined high temperature. The other constructions are the same as those of the first embodiment.

In the third embodiment with such a construction, micro coils are manufactured by the gas-phase growth according to the manufacturing process mentioned in the first embodiment. Additionally, in the manufacturing process, the temperature sensor 60 of each main body B detects the temperature at the center portion inside the hollow portion of the cylindrical substrate 30 of the corresponding main body B as the temperature of the container body 20a of the corresponding main body B.

And, the heating process of the container body 20a of each main body B is performed at the heat process S2, as same as in the first embodiment, together with the nitrogen gas supply process S1 of the manufacturing process shown in Fig. 9 or after the nitrogen gas supply process S1. In the heating process, each corresponding temperature controller 70 receives the AC voltage from the AC power supply PS under closure of the operating switch SW and is conditioned in its operation to control each corresponding heater 50 on a basis of the actual detection temperature of each corresponding temperature sensor 60 so as to generate heat from each corresponding heater 50.

Accordingly, the heater 50 of each heating circuit E heats the corresponding container body 20a so as to increase and maintain the temperature of the corresponding container body 20a at the predetermined high temperature of 750 °C.

Further, at the source gas introduction process S5, the source gases, that is, the mixture gas of the acetylene gas, the hydrogen gas and the hydrogen sulfide gas which are supplied from the source gas supply source are introduced into the corresponding container body 20a from the left side thereof through each source gas introduction pipe of the three sets of the corresponding source gas introduction pipe groups 20b to 20d for each container body 20a.

Accordingly, a reaction is started between the source gases and the metal catalyst of the catalyst layer 32 for each reaction container 20. Then, for each reaction container 20, micro coils grow intensively in a circle having a diameter within the range two to third times the inner diameter of the source gas introduction pipe as the same as in the first embodiment.

Thereafter, when the reaction between the source gases and the metal catalyst of the catalyst layer 32 ends for each reaction container 20, the cylindrical substrate 30 is extracted from the interior of the container body 20a and micro coils are collected as the substantially same as in the first embodiment.

Thus, micro coils collected in this way can be obtained in a large quantity for each reaction container according to the stacking number of the main bodies B with high purity as the solenoid-shaped micro coils which are regularly wound with the constant coil diameter as the same as in the first embodiment.

Furthermore, according to the stacked main body Ba of the manufacturing apparatus mentioned in the third embodiment, for each main body B, each source gas introduction pipe of the three sets of the source gas introduction pipe groups 20b to 20d of the reaction container 20 and each gas discharge pipe of the gas discharge pipe group 20f are extended horizontally from the casing 10 in parallel with the horizontal plane L of the base toward the opposite directions to each other from the left and right side walls 26a and 26b of the container body 20a.

Accordingly, in the manufacturing apparatus of the third embodiment, the respective main bodies B can be easily stacked without any interference with the three sets of the source gas introduction pipe groups 20b to 20d and the gas discharge pipe group 20f when stacking the mains bodies upward at each casing 10. Thus, it is possible to increase the coil yield amount and the coil yield rate of the micro coils in proportion to the stacking number of the main bodies and also to decrease the installation area of the manufacturing apparatus in the factory or the like so as to enhance the use efficiency in the factory or the like. The other operation and effect are the same as those of the first embodiment.

In addition, for embodying the present invention, the following various modifications may be exemplified without any limitation to the above-described embodiments.
(1) For embodying the present invention, the container body 20a of the reaction container 20 is not limited to the the transparent quartz mentioned in the above-described embodiment and may be formed from various materials which are non-transparent quartz, a heat-resistance metal such as nickel, stainless, hastelloy, tungsten or titanium, alumina or ceramics or may be formed by a reaction cylinder which is subjected to ceramics lining at its inner surface.
(2) For embodying the present invention, the base body 31 of the cylindrical substrate 30 may be formed from non-transparent quartz without any limitation to the transparent quartz.
(3) For embodying the present invention, the catalyst layer 32 may be formed by a metal plate or a sintered plate of powders of the metal catalyst without any limitation to the powders of the metal catalyst.
(4) For embodying the present invention, the catalyst layer 32 may be formed by coating a dispersion liquid of powders of the metal catalyst into water, alcohol or the like on the outer peripheral surface of the base body 31 or may be formed by a nickel catalyst layer formed by coating a solution of a nickel compound on the outer peripheral surface of the base body 31, differing from the above-mentioned first embodiment.

In this case, the thickness of the nickel catalyst layer is desirably a value within the range of 3 (µm) to 6 (µm). In case the thickness of the nickel catalyst layer is thin and less than 3 (µm), temperature is abnormally increased in the nickel catalyst layer when starting the reaction with the source gases of the nickel catalyst layer, thereby to deposit a rigid carbon layer thickly. As a result, the yield amount and the yield rate of the coil-shaped carbon fiber are degraded. From this reason, the thickness of the nickel catalyst layer is desirably equal to 3 (µm) or more.
(5) For embodying the present invention, each source gas introduction pipe of the source gas introduction pipe groups 20b to 20d may be connected or bonded at its base end opening portion to the container body 20a so as to oppose or face the outer peripheral surface of the cylindrical substrate 30 over about a one-third or more of the area thereof, differing from the above-mentioned first embodiment.

Accordingly, the introduction quantity of the source gases into the container body 20a by the source gas introduction pipe groups 20b to 20d can be ensured as an appropriate quantity under the reaction.
(6) For embodying the present invention, the number of the gas discharge pipes 28 is not limited to the number mentioned in the first embodiment, and may be predetermined to be a number within the range of 1/3 to 1/20 for the number of the entire source gas introduction pipes 23 to 25. The number of the gas discharge pipes 28 may be preferably predetermined to be a number in the range of 1/5 to 1/10.
(7) For embodying the present invention, in a state where the container body 20a is maintained at the high temperature, an external energy field such as a static electric field, a variable electric field, an ultrasonic field, a static magnetic field, a variable magnetic field, plasma field or the like may act singly or superposedly on the reaction field (the reaction field of the source gases with the catalyst) within the reaction container 20a.

Accordingly, dispersion or mixture of the source gas species, activation of the molecular movement of the source gas species, activation of the internal energy of the source gas species, improvement of catalyst activation and the like are caused by the external energy field to be capable of promoting the thermal decomposition reaction of the source gases with the catalyst. As a result, it is possible to improve the coil yield amount and the coil yield rate of the micro coils.

Furthermore, the anisotropy of the catalyst activity in the crystal face of the metal catalyst is decreased by the superposing effect of the external energy field to be capable of obtaining micro coils respectively with a small coil diameter. On the contrary, the anisotropy is increased by the superposing effect of the external energy field to be capable of obtaining micro coils respectively with a large coil diameter. This means that the coil diameter and the coil pitch of the micro coil may be controlled.
(8) For embodying the present invention, the stacking number of the main bodies B mentioned in the third embodiment is not limited to three and may be appropriately increased or decreased if necessary.
(9) For embodying the present invention, a polygonal substrate or a flat substrate may be adopted in replacement with the cylindrical substrate 30 mentioned in the first embodiment.
(10) For embodying the present invention, both the front and rear end covers 40 of the main body B mentioned in the first embodiment are not limited to the U-shaped cross-sectional shape and may be respectively an end cover of a simple flat shape. In addition, the respective end covers of the flat shape may be abutted at their outer peripheral surfaces respectively to both front and rear end surfaces of the cylindrical container body 20a through the heat-resistance O-rings and be detachably attached thereto by, for example, a plurality of screws.
(11) For embodying the present invention, the source gas introduction pipe group 20d of the source gas introduction pipe groups 20b to 20d mentioned in the first embodiment may be extended rightward through the right wall 14 of the casing 10 from the upper portion (facing the upper portion of the left semi-circular cylinder portion 26a) of the right semi-circular cylinder portion 26b of the container body 20a, differing from the first embodiment.

Specifically, each source gas introduction pipe 25 may be extended rightwardly from the upper portion of the right semi-circular cylinder portion 26b of the container body 20a so as to be positioned above each gas discharge pipe 28.

Accordingly, when introducing the source gases into the container body 20a through each source gas introduction pipe 25, the source gases can be smoothly introduced into the container body 20a without blocking the interior of each source gas introduction pipe 25. As a result, the amount of the precipitates deposited in the container body 20a can be increased compared to the amount of the precipitates deposited by the introduction of the source gases into the container body 20a using each source gas introduction pipe 25 mentioned in the first embodiment.
(12) For embodying the present invention, each source gas introduction pipe of the respective source gas introduction pipe groups 20b, 20c and 20d in the reaction container 20 mentioned in the first embodiment may be extended obliquely downward rather than the left direction of the reaction container 20 and each gas discharge pipe of the gas discharge pipe group 20f may be extended obliquely upward (the opposite direction to the extending direction of each source gas introduction pipe) rather than the right direction of the reaction container 20, differing from the first embodiment. In addition, similarly, each seal gas injection pipe of the seal gas injection pipe group 20e may be also extended obliquely downward like each source gas introduction pipe.

## Claims

1. A manufacturing method of micro coils, comprising:
a heat process for heating and maintaining a cylindrical container body (20a) of a reaction container (20) at a predetermined temperature, said container body (20a) either including first and second lateral semi-circular cylinder portions (26a, 26b) or lower and upper semi-circular cylinder portions, said reaction container (20) including said container body (20a) and a substrate (30) inserted into said container body (20a) in the axial direction and carrying a catalyst exhibiting anisotropy in a catalyst activity, having a thickness of at least 2 µm and facing the inner peripheral surface of said container body (20a) so as to introduce source gases producing gaseous carbon species when thermally decomposed into said container body (20a) either from said first lateral semi-circular cylinder portion (26a) or said lower semi-circular cylinder portion of said container body (20a) and to discharge gases in said container body (20a) either from said second lateral semi-circular cylinder portion (26b) or said upper semi-circular cylinder portion of said container body (20a); and
a source gas introduction process for introducing the source gases into said container body (20a) either from said first lateral semi-circular cylinder portion (26a) or said lower semi-circular cylinder portion;
wherein at the source gas introducing process, the source gases introduced into the container body (20a) which is maintained at the predetermined temperature are thermally decomposed by the catalyst so as to produce gaseous carbon species on the substrate (30), thereby to grow and manufacture the micro coils from the substrate (30) on a basis of the gaseous carbon species.

2. The manufacturing method of micro coils according to claim 1,
wherein said substrate (30) includes a cylindrical base body (31) which is inserted into said cylindrical container body (20a) in the axial direction to carry the catalyst on the outer peripheral surface thereof, and
wherein at the source gas introduction process, the source gases introduced into said cylindrical container body (20a) which is maintained at the predetermined temperature are thermally decomposed by the catalyst so as to produce gaseous carbon species on the outer peripheral surface of said cylindrical base body (31), thereby to grow and manufacture the micro coils on the outer peripheral surface of said cylindrical base body (31) on a basis of the gaseous carbon species.

3. The manufacturing method of micro coils according to claim 1, wherein the source gases are a mixed gas which include an acetylene gas, a hydrogen gas and a hydrogen sulfide gas, and
wherein at the heat process, the predetermined temperature is set as a temperature within the range of 600 °C to 900 °C and said container body (20a) is heated and maintained at the temperature.

4. The manufacturing method of micro coils according to claim 2, wherein the source gases are a mixed gas which include an acetylene gas, a hydrogen gas and a hydrogen sulfide gas, and
wherein at the heat process, the predetermined temperature is set as a temperature within the range of 600 °C to 900 °C and said container body (20a) is heated and maintained at the temperature.

5. A manufacturing apparatus of micro coils comprising:
a casing (10),
a reaction container (20),
a substrate (30), and
a heat controller;
wherein said reaction container (20) includes;
a cylindrical container body (20a) inserted into said casing (10) in the axial direction, said container body (20a) including first and second lateral semi-circular cylinder portions (26a, 26b),
at least one source gas introduction pipe (23, 24, 25) extended outwardly from said first lateral semi-circular cylinder portion (26a) of said container body (20a) so as to introduce source gases from a source gas supply source into said container body (20a), the source gases producing gaseous carbon species when thermally decomposed,
at least one gas discharge pipe (28) extended outwardly in the direction opposite to said at least one source gas introduction pipe (23, 24, 25) from said second lateral semi-circular cylinder portion (26b) of said container body (20a) so as to discharge gases in said container body (20a);
wherein said substrate (30) is inserted into said container body (20a) in the axial direction to carry a catalyst so as to face the inner peripheral surface of said container body (20a), said catalyst exhibiting anisotropy in a catalyst activity and having a thickness of at least 2 µm;
wherein said heat controller controls thermally and maintains said container body (20a) at a predetermined temperature; and
wherein the source gases in said container body (20a) are thermally decomposed by the catalyst under maintaining said container body (20a) at the predetermined temperature to produce gaseous carbon species on said substrate (30), thereby to grow and manufacture micro coils from said substrate (30) on a basis of the gaseous carbon species.

6. The manufacturing apparatus of micro coils according to claim 5, wherein said substrate (30) includes a cylindrical base body (31) inserted into the cylindrical container body (20a) in the axial direction to carry the catalyst on its outer peripheral surface.

7. The manufacturing apparatus of micro coils according to claim 6,
wherein said cylindrical substrate (30) includes a cylindrical base body (31) and a catalyst layer (32), said catalyst layer (32) being formed from nickel which is subjected to a partial oxidization treatment and a partial sulfurization treatment at its surface and coated as a catalyst on the outer peripheral surface of said cylindrical base body (31) with said thickness within the range of 2 µm to 6 µm so as to be carried on the outer peripheral surface of said cylindrical base body (31).

8. The manufacturing apparatus of micro coils according to claim 6,
wherein said at least one source gas introduction pipe (23, 24, 25) is a plurality of source gas introduction pipes (23, 24, 25) which are extended at an interval within twenty times the inner diameter of said source gas introduction pipe (23, 24, 25) in the axial direction of said cylindrical substrate (30) from a portion corresponding to the length of 1/3 or more of the axial length of said cylindrical substrate (30), and
wherein a radial direction facing interval between the outer peripheral surface of said cylindrical substrate (30) and an inner end opening portion of said source gas introduction pipe (23, 24, 25) is set to a value within the range of 5 mm to 50 mm.

9. The manufacturing apparatus of micro coils according to claim 7,
wherein said at least one source gas introduction pipe (23, 24, 25) is a plurality of source gas introduction pipes (23, 24, 25) which are extended at an interval within twenty times the inner diameter of said source gas introduction pipe (23, 24, 25) in the axial direction of said cylindrical substrate (30) from a portion corresponding to the length of 1/3 or more of the axial length of said cylindrical substrate (30), and
wherein a radial direction facing interval between the outer peripheral surface of said cylindrical substrate (30) and an inner end opening portion of said source gas introduction pipe (23, 24, 25) is set to a value within the range of 5 mm to 50 mm

10. The manufacturing apparatus of micro coils according to claim 5, which includes respective pluralities of said casing (10), said reaction container (20), said substrate (30) and said heat controller,
wherein a plurality of said casings (10) are respectively stacked in the up-and-down direction,
wherein a plurality of said reaction containers (20) are inserted at each cylindrical container body (20a) thereof into each corresponding casing (10) of a plurality of said casings (10) in the axial direction, each at least one source gas introduction pipe (23, 24, 25) of a plurality of said reaction containers (20) being extended outwardly from the one lateral direction wall portion of each corresponding cylindrical container body (20a), and each at least one gas discharge pipe (28) of a plurality of said reaction containers (20) being extended outwardly from the other lateral direction wall portion,
wherein a plurality of said substrates (30) are inserted respectively into the corresponding container bodies in the axial direction to carry each catalyst so as to face it to each inner peripheral surface of the corresponding container bodies,
wherein a plurality of said heat controllers perform respectively a heating control so as to maintain the corresponding container bodies at the predetermined temperature, and
wherein the source gases inside each corresponding container body (20a) are thermally decomposed by each corresponding catalyst under maintaining each corresponding container body (20a) at the predetermined temperature so as to produce gaseous carbon species on each corresponding substrate (30), thereby to grow micro coils from each corresponding substrate (30) on a basis of the gaseous carbon species.

## Patentansprüche

1. Herstellungsverfahren von Mikrospulen, mit:
einem Erwärmungsprozess zum Erwärmen und Aufrechterhalten eines zylindrischen Behälterkörpers (20a) eines Reaktionsbehälters (20) auf eine vorbestimmte Temperatur, wobei der Behälterkörper (20a) entweder einen ersten und einen zweiten seitlichen, halbrunden Zylinderabschnitt (26a, 26b) oder einen unteren und einen oberen halbrunden Zylinderabschnitt aufweist, wobei der Reaktionsbehälter (20) einschließlich des Behälterkörpers (20a) und eines Substrats (30), das in dem Behälterkörper (20a) in der axialen Richtung eingefügt ist und einen Katalysator trägt, der bei einer katalytischen Aktivität eine Anisotropie zeigt, eine Dicke von zumindest 2 µm hat und der Innenumfangsfläche des Behälterkörpers (20a) zugewandt ist, um so Quellengase, die gasförmige Kohlenstoffspezies erzeugen, wenn sie in dem Behälterkörper (20a) thermisch zerlegt werden, entweder von dem ersten seitlichen, halbrunden Zylinderabschnitt (26a) oder dem unteren halbrunden Zylinderabschnitt des Behälterkörpers (20a) einzuführen, und um Gase in dem Behälterkörper (20a) entweder von dem zweiten seitlichen, halbrunden Zylinderabschnitt (26b) oder dem oberen halbrunden Zylinderabschnitt des Behälterkörpers (20a) auszulassen; und
einem Quellengaseinführungsprozess zum Einführen des Quellengases in den Behälterkörper (20a) entweder von dem ersten seitlichen, halbrunden Zylinderabschnitt (26a) oder dem unteren halbrunden Zylinderabschnitt;
wobei bei dem Quellengaseinführungsprozess die Quellengase, die in den Behälterkörper (20a) eingeführt werden, der auf die vorbestimmte Temperatur aufrecht erhalten wird, durch den Katalysator thermisch zerlegt werden, um so gasförmige Kohlenstoffspezies an dem Substrat (30) zu erzeugen, wodurch die Mikrospulen an dem Substrat (30) auf der Grundlage der gasförmigen Kohlenstoffspezies anwachsen und hergestellt werden.

2. Herstellungsverfahren von Mikrospulen gemäß Anspruch 1, wobei das Substrat (30) einen zylindrischen Basiskörper (31) aufweist, der in den zylindrischen Behälterkörper (20) in der axialen Richtung eingefügt wird, um den Katalysator an der Außenumfangsfläche davon zu tragen, und
wobei bei dem Quellengaseinführungsprozess die Quellengase, die in den zylindrischen Behälterkörper (20a) eingeführt werden, der auf die vorbestimmte Temperatur aufrecht erhalten wird, durch den Katalysator thermisch zerlegt werden, um so gasförmige Kohlenstoffspezies an der Außenumfangsfläche des zylindrischen Basiskörpers (31) zu erzeugen, wodurch die Mikrospulen an der Außenumfangsfläche des zylindrischen Basiskörpers (31) auf der Grundlage der gasförmigen Kohlenstoffspezies anwachsen und hergestellt werden.

3. Herstellungsverfahren von Mikrospulen gemäß Anspruch 1, wobei die Quellengase ein gemischtes Gas sind, das Acethylengas, Wasserstoffgas und ein Schwefelwasserstoffgas enthält, und
wobei bei dem Erwärmungsprozess die vorbestimmte Temperatur als eine Temperatur innerhalb des Bereiches von 600°C bis 900°C eingestellt wird und der Behälterkörper (20a) auf die Temperatur erwärmt und aufrecht erhalten wird.

4. Herstellungsverfahren von Mikrospulen gemäß Anspruch 2, wobei die Quellengase ein gemischtes Gas sind, das Acethylengas, Wasserstoffgas und ein Schwefelwasserstoffgas enthält, und
wobei bei dem Erwärmungsprozess die vorbestimmte Temperatur als eine Temperatur innerhalb des Bereiches von 600°C bis 900°C eingestellt wird und der Behälterkörper (20a) erwärmt wird und auf die Temperatur aufrecht erhalten wird.

5. Herstellungsgerät für Mikrospulen, mit:
einem Gehäuse (10),
einem Reaktionsbehälter (20),
einem Substrat (30), und
einer Erwärmungssteuervorrichtung;
wobei der Reaktionsbehälter (20) folgendes aufweist:
einen zylindrischen Behälterkörper (20a), der in das Gehäuse (10) in der axialen Richtung eingefügt ist, wobei der Behälterkörper (20a) einen ersten und einen zweiten halbrunden Zylinderabschnitt (26a, 26b) aufweist,
zumindest ein Quellengaseinführungsrohr (23, 24, 25), das sich von dem ersten seitlichen, halbrunden Zylinderabschnitt (26a) des Behälterkörpers (20a) nach außen erstreckt, um so Quellengase von einer Quellengaszuführungsquelle in den Behälterkörper (20a) einzuführen, wobei die Quellengase gasförmige Kohlenstoffspezies erzeugen, wenn sie thermisch zerlegt werden,
zumindest ein Gasauslassrohr (28), das sich in der Richtung entgegen dem zumindest einen Quellengaseinführungsrohr (23, 24, 25) von dem zweiten seitlichen, halbrunden Zylinderabschnitt (26b) des Behälterkörpers (20a) nach außen erstreckt, um Gase in dem Behälterkörper (20a) auszulassen;
wobei das Substrat (30) in dem Behälterkörper (20a) in der axialen Richtung eingefügt ist, um einen Katalysator so zu tragen, dass dieser der Innenumfangsfläche des Behälterkörpers (20a) zugewandt ist, wobei der Katalysator bei einer katalytischen Aktivität eine Anisotropie zeigt und eine Dicke von zumindest 2 µm hat;
wobei die Erwärmungssteuervorrichtung die Erwärmung steuert und den Behälterkörper (20a) auf eine vorbestimmte Temperatur aufrechterhält; und
wobei das Quellengas in dem Behälterkörper (20a) durch den Katalysator unter Aufrechterhaltung des Behälterkörpers (20a) auf der vorbestimmten Temperatur thermisch zerlegt wird, um gasförmige Kohlenstoffspezies an dem Substrat (30) zu erzeugen, wodurch Mikrospulen an dem Substrat (30) auf der Grundlage der gasförmigen Kohlenstoffspezies anwachsen und hergestellt werden.

6. Herstellungsgerät für Mikrospulen gemäß Anspruch 5, wobei das Substrat (30) einen zylindrischen Basiskörper (31) aufweist, der in dem zylindrischen Behälterkörper (20a) in der axialen Richtung eingefügt ist, um den Katalysator an der Außenumfangsfläche davon zu tragen.

7. Herstellungsgerät für Mikrospulen gemäß Anspruch 6,
wobei das zylindrische Substrat (30) einen zylindrischen Basiskörper (31) und eine Katalysatorschicht (32) aufweist, wobei die Katalysatorschicht (32) aus Nickel gebildet ist, die einer partiellen Oxidationsbehandlung und einer partiellen Schwefelungsbehandlung an ihrer Oberfläche ausgesetzt ist und als ein Katalysator an der Außenumfangsfläche des zylindrischen Basiskörpers (31) mit der Dicke innerhalb des Bereiches von 2 µm bis 6 µm beschichtet ist, damit sie an der Außenumfangsfläche des zylindrischen Basiskörpers (31) getragen ist.

8. Herstellungsgerät für Mikrospulen gemäß Anspruch 6, wobei das zumindest eine Quellengaseinführungsrohr (23, 24, 25) aus vielen Quellengaseinführungsrohren (23, 24, 25) besteht, die sich in einem Intervall innerhalb des 20-fachen Innendurchmessers des Quellengaseinführungsrohrs (23, 24, 25) in der axialen Richtung des zylindrischen Substrats (30) von einem Abschnitt entsprechend der Länge von einem Drittel oder mehr der axialen Länge des zylindrischen Substrats (30) erstrecken, und
wobei ein in der radialen Richtung gerichtetes Intervall zwischen der Außenumfangsfläche des zylindrischen Substrats (30) und einem inneren Endöffnungsabschnitt des Quellengaseinführungsrohrs (23, 24, 25) auf einen Wert innerhalb des Bereiches von 5 mm bis 50 mm festgelegt ist.

9. Herstellungsgerät für Mikrospulen gemäß Anspruch 7, wobei das zumindest eine Quellengaseinführungsrohr (23, 24, 25) aus vielen Quellengaseinführungsrohren (23, 24, 25) besteht, die sich in einem Intervall innerhalb des 20-fachen Innendurchmessers des Quellengaseinführungsrohrs (23, 24, 25) in der axialen Richtung des zylindrischen Substrats (30) von einem Abschnitt entsprechend der Länge von einem Drittel oder mehr der axialen Länge des zylindrischen Substrats (30) erstrecken, und
wobei ein in der radialen Richtung gerichtetes Intervall zwischen der Außenumfangsfläche des zylindrischen Substrats (30) und einem inneren Endöffnungsabschnitt des Quellengaseinführungsrohrs (23, 24, 25) auf einen Wert innerhalb des Bereiches von 5 mm bis 50 mm festgelegt ist.

10. Herstellungsgerät für Mikrospulen gemäß Anspruch 5, das verschiedene Mehrzahlen des Gehäuses (10), des Reaktionsbehälters (20) und des Substrates (30) und der Erwärmungssteuervorrichtung aufweist,
wobei eine Mehrzahl der Gehäuse (10) entsprechend in der Oben/Unten-Richtung gestapelt ist,
wobei eine Mehrzahl der Reaktionsbehälter (20) an dessen jeweiligen zylindrischen Behälterkörpern (20a) in ein entsprechendes Gehäuse (10) der Mehrzahl der Gehäuse (10) in der axialen Richtung eingefügt ist, wobei sich zumindest ein Quellengaseinführungsrohr (23, 24, 25) der Mehrzahl der Reaktionsbehälter (20) von dem einen Wandabschnitt in der seitlichen Richtung des entsprechenden zylindrischen Behälterkörpers (20a) nach außen erstreckt, und wobei sich jeweils zumindest ein Auslassrohr (28) der Mehrzahl der Reaktionsbehälter (20) von dem anderen Wandabschnitt in der seitlichen Richtung nach außen erstreckt,
wobei entsprechend eine Mehrzahl der Substrate (30) in die entsprechenden Behälterkörper in der axialen Richtung eingefügt ist, um den entsprechenden Katalysator so zu tragen, dass dieser der entsprechenden Innenumfangsfläche der entsprechenden Behälterkörper zugewandt ist,
wobei eine Mehrzahl der Erwärmungssteuervorrichtungen jeweils eine Erwärmungssteuerung durchführt, um so die entsprechenden Behälterkörper auf die vorbestimmte Temperatur aufrecht zu erhalten, und
wobei die Quellengase im Inneren der entsprechenden Behälterkörper (20a) durch den jeweils entsprechenden Katalysator unter Aufrechterhaltung des jeweiligen entsprechenden Behälterkörpers (20a) auf die vorbestimmte Temperatur thermisch zerlegt werden, um so gasförmige Kohlenstoffspezies an dem jeweils entsprechenden Substrat (30) zu erzeugen, wodurch Mikrospulen an dem entsprechenden Substrat (30) auf der Grundlage der gasförmigen Kohlenstoffspezies anwachsen.

## Revendications

1. Procédé de fabrication de micro-bobines, comprenant :
une opération de chauffage destinée à chauffeur et à maintenir un corps de conteneur cylindrique (20a) d'un conteneur de réaction (20) à une température prédéterminée, ledit corps de conteneur (20a) comportant soit des première et seconde parties de cylindre semi-circulaires latérales (26a, 26b) soit des parties de cylindre semi-circulaires inférieure et supérieure, ledit conteneur de réaction (20) comportant ledit corps de conteneur (20a) et un substrat (30) inséré dans ledit corps de conteneur (20a) suivant la direction axiale et supportant un catalyseur présentant une anisotropie dans une activité de catalyseur, ayant une épaisseur d'au moins 2 µm et faisant face à la surface périphérique interne dudit corps de conteneur (20a) de manière à introduire des gaz de source produisant des éléments carbonés gazeux lorsqu'ils sont décomposés thermiquement dans ledit corps de conteneur (20a) à partir soit de ladite première partie de cylindre semi-circulaire latérale (26a) soit de ladite partie de cylindre semi-circulaire inférieure dudit corps de conteneur (20a) et à décharger des gaz dans ledit corps de conteneur (20a) à partir soit de ladite seconde partie de cylindre semi-circulaire latérale (26b) soit de ladite partie de cylindre semi-circulaire supérieure dudit corps de conteneur (20a) ; et
une opération d'introduction de gaz de source destinée à introduire les gaz de source dans ledit corps de conteneur (20a) à partir soit de ladite première partie de cylindre semi-circulaire latérale (26a) soit de ladite partie de cylindre semi-circulaire inférieure ;
dans lequel, lors de l'opération d'introduction de gaz de source, les gaz de source introduits dans le corps de conteneur (20a), qui est maintenu à la température prédéterminée, sont décomposés thermiquement par le catalyseur de manière à produire les éléments carbonés gazeux sur le substrat (30), assurant ainsi la croissance et la fabrication des micro-bobines à partir du substrat (30) sur une base des éléments carbonés gazeux.

2. Procédé de fabrication de micro-bobines selon la revendication 1,
dans lequel ledit substrat (30) comporte un corps de base cylindrique (31) qui est inséré dans ledit corps de conteneur cylindrique (20a) dans la direction axiale afin de supporter le catalyseur sur sa surface périphérique externe, et
dans lequel, lors de l'opération d'introduction de gaz de source, les gaz de source introduits dans ledit corps de conteneur cylindrique (20a) qui est maintenu à la température prédéterminée sont décomposés thermiquement par le catalyseur de manière à produire des éléments carbonés gazeux sur la surface périphérique externe dudit corps de base cylindrique (31), assurant ainsi la croissance et la fabrication des micro-bobines sur la surface périphérique externe dudit corps de base cylindrique (31) sur la base des éléments carbonés gazeux.

3. Procédé de fabrication de micro-bobines selon la revendication 1, dans lequel les gaz de source sont un mélange gazeux qui comporte de l'acétylène gazeux, de l'hydrogène gazeux et du sulfure d'hydrogène gazeux, et
dans lequel, lors de l'opération de chauffage, la température prédéterminée est réglée à une température comprise dans une plage de 600° C à 900° C et ledit corps de conteneur (20a) est chauffé et maintenu à la température.

4. Procédé de fabrication de micro-bobines selon la revendication 2, dans lequel les gaz de source sont un mélange gazeux qui comporte de l'acétylène gazeux, de l'hydrogène gazeux et du sulfure d'hydrogène gazeux, et
dans lequel lors de l'opération de chauffage, la température prédéterminée est réglée à une température comprise dans une plage de 600° C à 900° C et ledit corps de conteneur (20a) est chauffé et maintenu à la température.

5. Dispositif de fabrication de micro-bobines comprenant :
un boîtier (10),
un conteneur de réaction (20),
un substrat (30), et
une unité de commande de chauffage ;
dans lequel ledit conteneur de réaction (20) comporte ;
un corps de conteneur cylindrique (20a) inséré dans ledit boîtier (10) dans la direction axiale, ledit corps de conteneur (20a) comportant des première et seconde parties de cylindre semi-circulaires latérales (26a, 26b),
au moins une tuyauterie d'introduction de gaz de source (23, 24, 25) s'étendant vers l'extérieur à partir de ladite première partie de cylindre semi-circulaire latérale (26a) dudit corps de conteneur (20a) de manière à introduire des gaz de source à partir d'une source d'alimentation en gaz de source dans ledit corps de conteneur (20a), les gaz de source produisant des éléments carbonés gazeux lorsqu'il sont décomposés thermiquement,
au moins une tuyauterie de déchargement de gaz (28) s'étendant vers l'extérieur dans la direction opposée à ladite au moins une tuyauterie d'introduction de gaz de source (23, 24, 25) à partir de ladite seconde partie de cylindre semi-circulaire latérale (26b) dudit corps de conteneur (20a) de manière à décharger des gaz dans ledit corps de conteneur (20a) ;
dans lequel ledit substrat (30) est inséré dans ledit corps de conteneur (20a) dans la direction axiale pour supporter un catalyseur de manière à faire face à la surface périphérique interne dudit corps de conteneur (20a), ledit catalyseur présentant une anisotropie dans une activité de catalyseur et ayant une épaisseur d'au moins 2 µm ;
dans lequel ladite unité de commande de chauffage commande thermiquement ledit corps de conteneur (20a) et le maintient à une température prédéterminée ; et
dans lequel les gaz de source dans ledit corps de conteneur (20a) sont décomposés thermiquement par le catalyseur en maintenant ledit corps de conteneur (20a) à la température prédéterminée afin de produire des éléments carbonés gazeux sur ledit substrat (30), assurant ainsi la croissance et la fabrication des micro-bobines à partir dudit substrat (30) sur une base des éléments carbonés gazeux.

6. Dispositif de fabrication de micro-bobines selon la revendication 5, dans lequel ledit substrat (30) comporte un corps de base cylindrique (31) inséré dans le corps de conteneur cylindrique (20a) dans la direction axiale afin de supporter le catalyseur sur sa surface périphérique externe.

7. Dispositif de fabrication de micro-bobines selon la revendication 6, dans lequel ledit substrat cylindrique (30) comporte un corps de base cylindrique (31) et une couche de catalyseur (32), ladite couche de catalyseur (32) étant formée à partir de nickel qui est soumis à un traitement d'oxydation partielle et à un traitement de sulfuration partielle au niveau de sa surface, et déposée en tant que catalyseur sur la surface périphérique externe dudit corps de base cylindrique (31), ladite épaisseur étant comprise à l'intérieur d'une plage de 2 µm à 6 µm de manière à être supportée sur la surface périphérique externe dudit corps de base cylindrique (31).

8. Dispositif de fabrication de micro-bobines selon la revendication 6, dans lequel ladite au moins une tuyauterie d'introduction de gaz de source (23, 24, 25) est une pluralité de tuyauteries d'introduction de gaz de source (23, 24, 25) qui s'étendent à un intervalle inférieur à vingt fois le diamètre interne de ladite tuyauterie d'introduction de gaz de source (23, 24, 25) dans la direction axiale dudit substrat cylindrique (30) à partir d'une partie correspondant à la longueur d'1/3 ou plus de la longueur axiale dudit substrat cylindrique (30), et
dans lequel un intervalle face à la direction radiale entre la surface périphérique externe dudit substrat cylindrique (30) et une partie d'ouverture d'extrémité interne de ladite tuyauterie d'introduction de gaz de source (23, 24, 25) est défini à une valeur comprise dans une plage de 5 mm à 50 mm.

9. Dispositif de fabrication de micro-bobines selon la revendication 7,
dans lequel ladite au moins une tuyauterie d'introduction de gaz de source (23, 24, 25) est constituée par une pluralité de tuyauteries d'introduction de gaz de source (23, 24, 25) qui s'étendent suivant un intervalle inférieur à vingt fois le diamètre interne de ladite tuyauterie d'introduction de gaz de source (23, 24, 25) dans la direction axiale dudit substrat cylindrique (30) à partir d'une partie correspondant à la longueur d'1/3 ou plus de la longueur axiale dudit substrat cylindrique (30), et
dans lequel un intervalle face à la direction radiale entre la surface périphérique externe dudit substrat cylindrique (30) et une partie d'ouverture d'extrémité interne de ladite tuyauterie d'introduction de gaz de source (23, 24, 25) est défini à une valeur comprise dans une plage de 5 mm à 50 mm.

10. Dispositif de fabrication de micro-bobines selon la revendication 5, qui comporte des pluralités respectives dudit boîtier (10), dudit conteneur de réaction (20), dudit substrat (30) et de ladite unité de commande de chauffage,
dans lequel des boîtiers d'une pluralité desdits boîtiers (10) sont empilés respectivement dans la direction verticale,
dans lequel des conteneurs d'une pluralité desdits conteneurs de réaction (20) sont insérés au niveau de chaque corps de conteneur cylindrique (20a) de ceux-ci dans chaque boîtier correspondant (10) d'une pluralité desdits boîtiers (10) dans la direction axiale, chaque au moins une tuyauterie d'introduction de gaz de source (23, 24, 25) d'une pluralité desdits conteneurs de réaction (20) s'étendant vers l'extérieur à partir de la première partie de paroi de direction latérale de chaque corps de conteneur cylindrique correspondant (20a), et chaque au moins une tuyauterie de déchargement de gaz (28) d'une pluralité desdits conteneurs de réaction (20) s'étendant vers l'extérieur à partir de l'autre partie de paroi dans la direction latérale,
dans lequel les substrats d'une pluralité desdits substrats (30) sont insérés respectivement dans les corps de conteneurs correspondants dans la direction axiale afin de supporter chaque catalyseur de manière à l'orienter face à chaque surface périphérique interne des corps de conteneurs correspondants,
dans lequel les unités d'une pluralité desdites unités de commande de chauffage exécutent respectivement une commande de chauffage afin de maintenir les corps de conteneurs correspondants à la température prédéterminée, et
dans lequel les gaz de source à l'intérieur de chaque corps de conteneur correspondant (20a) sont décomposés thermiquement par chaque catalyseur correspondant en maintenant chaque corps de conteneur correspondant (20a) à la température prédéterminée de manière à produire des éléments carbonés gazeux sur chaque substrat (30) correspondant, assurant ainsi la croissance des micro-bobines à partir de chaque substrat (30) correspondant sur une base des éléments carbonés gazeux.
